# EUROPEAN PATENT SPECIFICATION

(11) **EP 2 498 298 B1**
(45) Date of publication and mention of the grant of the patent: **04.03.2015**
(21) Application number: 10828092.6
(22) Date of filing: 02.11.2010
(51) Int. Cl.: C08F 255/04, C09J 151/06, H01L 31/048

(54) **SOLAR CELL MODULE**
SOLARZELLENMODUL
MODULE DE PHOTOPILES

(30) Priority: 05.11.2009 JP 2009254259; 28.09.2010 JP 2010217080; 21.10.2010 JP 2010236115
(43) Date of publication of application: 12.09.2012
(73) Proprietor: KANEKA CORPORATION, Osaka (JP)
(72) Inventor: HIROSE, Fuminobu, Settsu-shi Osaka 566-0072 (JP); SHINOBU, Masahide, Settsu-shi Osaka 566-0072 (JP); WADA, Kazuhito, Settsu-shi Osaka 566-0072 (JP); NISHIZA, Kenichiro, Settsu-shi Osaka 566-0072 (JP); TANAKA, Katsuyuki, Settsu-shi Osaka 566-0072 (JP)
(74) Representative: Hoffmann Eitle
(86) International application number: PCT/JP2010/006457
(87) International publication number: WO 2011/055531

(56) References cited:
- JP-A- 2009 024 136
- JP-A- 2010 226 052
- US-A1- 2002 038 664

## Description

### Technical Field

The present invention relates to a solar cell sealing material using an epoxy-modified polyolefin-based resin composition and a solar cell module.

### Background Art

In recent years, solar cells, which directly convert sunlight into electric energy, have come to be widely used from the viewpoint of effective utilization of resources and prevention of environmental pollution. In order to promote more widespread use of solar cells, it is important to achieve performance required of automotive parts and architectural members such as long-term reliability and recyclability.

A solar cell module is a module usually obtained by fixing a solar cell element containing silicon (crystalline, polycrystalline, amorphous) or rare metals such as gallium-arsenic, copper-indium-selenium (CIS), or cadmium-tellurium (CdTe) and members for protecting the solar cell element, which are a light-receiving surface-side transparent protective member and a back surface-side protective member, to each other with a sealing material. The structure of a solar cell module slightly varies depending on the type of solar cell element used, but a solar cell element sealing material is required to have excellent adhesive properties to a solar cell element and protective members constituting the solar cell module. Particularly, solar cell modules are installed outdoors and exposed to increases in temperature and the weather, and therefore there is a fear that poor adhesion between a sealing material and adherends causes the entry of moisture and results in deterioration of solar cell elements.

From the viewpoint of flexibility and transparency, an ethylene-vinyl acetate (EVA) copolymer is currently used as a solar cell element sealing material in solar cell modules. However, an ethylene-vinyl acetate copolymer has low heat resistance and low adhesive properties, and therefore an organic peroxide and a silane coupling agent need to be used to improve heat resistance by cross-linking and to improve adhesive properties by the action of the silane coupling agent (Patent Document 1). In this case, an ethylene-vinyl acetate copolymer sheet containing such additives needs to be produced to seal a solar cell element with this sheet. In the stage of producing the sheet, molding needs to be performed at low temperature such that the organic peroxide is not decomposed, and therefore the speed of extrusion molding cannot be increased. Further, in the stage of sealing a solar cell element, a longtime cross-linking and bonding process needs to be performed in two steps, i.e., the step of temporary bonding using a laminator for several minutes to over ten minutes and the step of final bonding using an oven at high temperature, at which the organic peroxide is decomposed, for several tens of minutes to several hours. Therefore, the production of a solar cell module takes much time and effort, which is one of the causes of high production cost. Further, the cross-linked ethylene-vinyl acetate copolymer makes it difficult to collect solar cell elements from, for example, defective products produced in a solar cell module production process. Even when solar cell elements can be collected, the cross-linked ethylene-vinyl acetate copolymer cannot be recycled as a sealing material and is therefore poor in recyclability.

Meanwhile, polar resins such as EVA and polyvinyl butyral are currently used as solar cell sealing materials. Such resins have excellent adhesive properties to glass substrates and back sheets obtained by stacking PET films and the like due to their polar functional groups, and protect silicon substrates. On the other hand, EVA has excellent adhesive properties but is inferior in water vapor barrier properties to polyolefins. Further, when used to produce a solar cell, EVA needs to be subjected to heat treatment for a long period of time so as to be able to fully exert its adhesive properties, which is an issue affecting productivity.

Further, demand for EVA as a solar cell member has been increasing in recent years, and therefore it is pointed out that there is a possibility that supply of EVA will become scarce. For this reason, there is demand for resins as substitutes for EVA. Under the circumstances, researches on the application of modified polyolefins, such as those disclosed in the above Patent Documents, to solar cell sealing materials have been performed, but modified polyolefins having sufficient adhesive properties to glass as a substrate have not yet been found, nor modified polyolefins having transparency equivalent to that of EVA or polyvinyl butyral have not yet been found, neither.

Polyolefin-based resins, such as polypropylene-based resins, are excellent in moldability, flexibility, heat resistance, recyclability, chemical resistance, and electric insulating properties and are inexpensive, and are therefore generally and widely used to produce films, fibers, and other molded articles having various shapes. However, polypropylene-based materials are so-called non-polar polymer materials being extremely inactive and having no polar group in the molecule, and therefore have problems such as low adhesive properties and low coating properties due to significantly-low solubility in solvents.

In order to overcome such drawbacks, a copolymer of ethylene and a polymerizable monomer having a polar functional group has been studied (Patent Document 2). However, in the case of, for example, a copolymer of ethylene and a monomer having an epoxy group, an amino group-containing coupling agent needs to be used as an essential component. Such a copolymer has problems such as difficulty in industrial production and high production cost.

Further, a modified resin obtained by graft polymerization of a polymerizable monomer having a polar functional group onto an olefin-based resin has also been studied. As methods for producing such a modified resin, the following methods have been proposed.
(i) A method in which polyolefin resin particles dispersed in water are impregnated with a vinyl monomer and heated in the presence of a peroxide to produce a modified polyolefin (Patent Document 3).
(ii) A method in which a polyolefin resin, maleic anhydride, and an organic peroxide are melt-kneaded to produce a modified polyolefin (Patent Document 4).

In the case of the method (i), various vinyl-based monomers can be grafted onto a polyolefin resin. However, a monomer having a highly-polar functional group such as an epoxy group is less likely to be impregnated into a polyolefin resin with low polarity, and therefore there is a limit on the amount of the monomer copolymerized with the polyolefin resin. Further, this method requires the use of a dissolution inhibitor for inhibiting dissolution of the monomer in water, and therefore has a problem that the dissolution inhibitor remaining after reaction in a modified polyolefin composition affects coating properties and adhesive/cohesive properties.

The method (ii) has a limited choice of monomers copolymerizable with a polyolefin resin. For example, when glycidyl methacrylate is used instead of maleic anhydride, there is a case where the monomer is volatilized without reacting, grafting of the monomer onto the polyolefin resin does not occur but only the polymerization of the monomer occurs, or a reduction in the molecular weight of the polyolefin resin occurs due to the cleavage of its main chain by an excess of a peroxide so that coloring occurs or mechanical properties are reduced. Under the present circumstances, it cannot be said that modified polyolefins produced by such methods have reached a level sufficiently satisfying requirements imposed on adhesive properties.

On the other hand, as a composition having excellent adhesive properties, an epoxy-modified polyolefin-based resin composition obtained by grafting an epoxy group-containing vinyl monomer onto a polyolefin is known (Patent Document 5). However, it is conceivable that introduction of polar groups into a polyolefin will reduce water vapor barrier properties, and therefore the application of such an epoxy-modified polyolefin-based resin composition to solar cell modules required to have high moisture resistance has not been studied until now.

### Prior Art Documents

### Patent Documents

Patent Document 1: JP-A-2005-113077
Patent Document 2: JP-A-2001-144313
Patent Document 3: JP-A-6-122738
Patent Document 4: JP-A-9-278956
Patent Document 5: JP-A-2009-24136

### DISCLOSURE OF THE INVENTION

### Problems to be Solved by the Invention

An object of the present invention is to provide a high-performance and highly-reliable solar cell module sealed with a solar cell sealing material which allows solar cell quality to be maintained over a long period of time due to its excellent water vapor barrier properties and adhesive properties and which has excellent recyclability and module productivity.

### Means for Solving the Problems

In view of the above circumstances, the present inventors have extensively studied, and as a result have found that an epoxy-modified polyolefin has a water vapor transmission rate as low as about one-tenth of that of an ethylene-vinyl acetate copolymer used in members (sealing members) of solar cell modules. This finding has led to the completion of the present invention. Therefore, it is preferred that an epoxy-modified polyolefin-based resin composition according to the present invention does not contain an acidic functional group, such as maleic acid, that reduces water vapor barrier properties.

A solar cell sealing material according to the present invention containing such an epoxy-modified polyolefin-based resin composition has a low water vapor transmission rate, that is, excellent water vapor barrier properties as basic physical properties, and in addition, is less likely to cause decomposition gas generation during sealing and hydrolysis-induced acid generation affecting long-term module reliability which are problems for EVA.

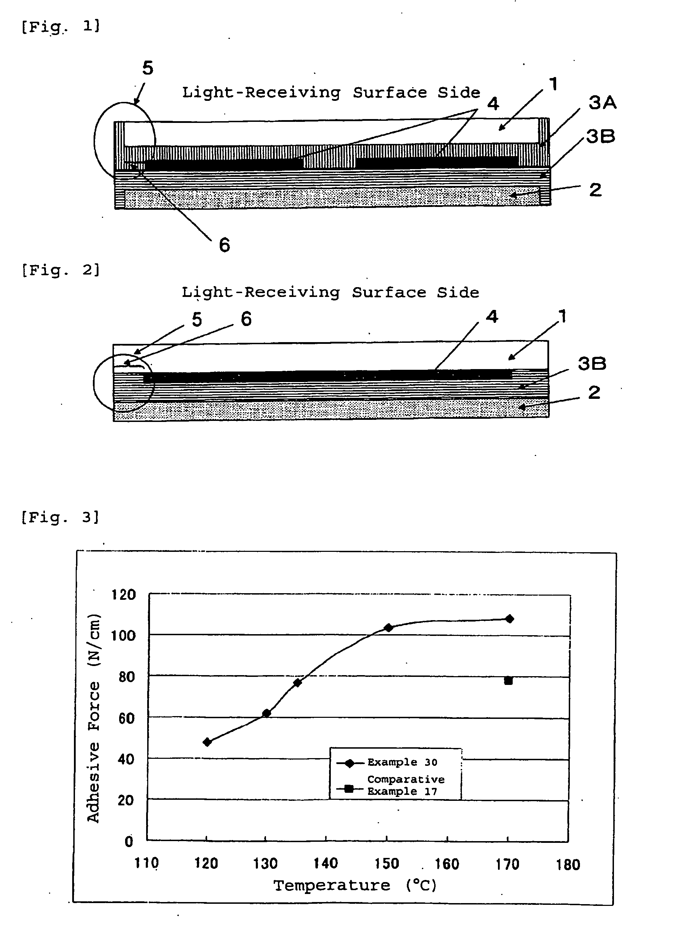

Further, EVA is hydrolyzable, and is therefore not usually used in an unprotected state in portions that are likely to come into contact with moisture, for example, in at least a peripheral portion of a solar cell panel surface of a solar cell module, preferably on a module end face orthogonal to the panel surface, that is, in an end-face seal portion (an end-face seal portion 5 shown in Figs. 1 and 2). Such portions that are likely to come into contact with moisture are usually separately sealed with a thermoplastic elastomer, such as thermoplastic butyl rubber, used as an end-face sealing material. However, the non-hydrolyzable modified polyolefin resin composition according to the present invention basically does not change in its physical properties even when coming into contact with moisture, and therefore can be used to seal not only a solar cell panel surface but also such an end-face seal portion.

Such a modified polyolefin resin composition according to the present invention is suitable as, for example, a solar cell sealing material due to its excellent water vapor barrier properties. Further, the use of such a modified polyolefin resin composition according to the present invention makes it possible to achieve higher productivity as compared to a case where EVA is used.

The modified polyolefin resin composition according to the present invention preferably has excellent adhesive properties to adhesion-resistant base materials, especially glass, glass plates, and fluorine-based resin sheets, and is therefore a solar cell sealing material having high reliability.

The modified polyolefin resin composition according to the present invention preferably has transparency (light transmittance) equivalent to that of EVA used to seal solar cells, and is therefore suitable as a material for sealing crystalline silicon solar cells.

More specifically, the present invention relates to a solar cell sealing material containing an epoxy-modified polyolefin-based resin composition obtained by introducing epoxy groups by a graft reaction and to a solar cell module sealed with such a solar cell sealing material. Such an epoxy-modified polyolefin-based resin composition according to the present invention is preferably obtained simply and easily at low cost by melt-kneading a polyolefin-based resin (a) with an epoxy group-containing vinyl monomer (c) and an aromatic vinyl monomer (d) in the presence of a radical polymerization initiator (b), which is advantageous from the viewpoint of supplying inexpensive large-area solar cell modules in large quantity. Further, as will be described later with reference to comparative examples, the epoxy-modified polyolefin-based resin composition according to the present invention is superior in properties required of a solar cell sealing material to an expensive ethylene-glycidyl methacrylate copolymer that cannot be simply and easily synthesized.

It is preferred that the solar cell sealing material is provided so as to come into contact with a solar cell surface and an end-face seal portion is sealed with the epoxy-modified polyolefin-based resin composition, the end-face seal portion including a planar portion which is in the same plane as the solar cell surface in the solar cell module and where a solar cell is not present.

That is, it is preferred that an end-face seal portion is sealed with the epoxy-modified polyolefin-based resin composition. Here, from the viewpoint of fully utilizing the characteristics of the nonhydrolyzable resin composition according to the present invention, the end-face seal portion includes at least a peripheral portion of a solar cell panel surface (e.g., an end-face seal portion 5 shown in Fig. 2), and from the viewpoint of reducing the number of sealing members, the end-face seal portion preferably includes a module end face orthogonal to the surface of a panel constituted from a glass plate, that is, a glass plate end face, that is, an end face corresponding to the thickness of the glass plate (e.g., an end-face seal portion 5 shown in Fig. 1) .

The term "peripheral portion" refers to a peripheral portion of a front glass plate or a back glass plate of a solar cell panel typified by a crystalline solar cell module, or a thin-film solar cell-equipped glass plate of a thin-film solar cell module. The width from the end face is a width from the end face, that is, from the outer periphery toward the inside in parallel with a work surface, and is 20 mm or less, preferably 10 mm or less, more preferably 5 mm or less. When a crystalline solar cell is used, the peripheral portion more preferably extends from the periphery of a seal surface of the glass plate, on which a solar cell is not present. When a thin-film solar cell is used, the peripheral portion is more preferably a portion formed by preferably removing layers including a transparent conductive layer formed on glass, to which the solar cell sealing material according to the present invention has excellent adhesive properties, by laser processing or sandblasting so that the surface of the glass is exposed, and the portion extends from the end face of glass. By doing so, the solar cell module can have extremely high long-term reliability due to the adhesive properties of the solar cell sealing material according to the present invention.

It is also preferred that the solar cell module includes a glass plate as a component, wherein the end-face seal portion to be sealed includes an end face of the glass plate. The solar cell sealing material according to the present invention has both high water vapor barrier properties and high adhesive properties to glass, and is therefore properly adhered to the end face of the glass plate. The sealing material on the end face of the glass plate preferably has a thickness of 0.1 mm to 5 mm, more preferably 0.2 mm to 3 mm in a direction perpendicular to the end face of the glass plate, which makes it possible to effectively prevent the entry of moisture into the interface between the glass plate and the sealing material. Therefore, the solar cell module according to the present invention has excellent weather resistance to withstand exposure to outdoors and therefore has high reliability.

Here, the term "crystalline solar cell" refers to a solar cell made of monocrystalline silicon, polycrystalline silicon, crystalline silicon obtained by depositing amorphous silicon onto monocrystalline silicon, or the like, and the term "thin-film solar cell" refers to a solar cell having an amorphous silicon photoelectric conversion unit, a microcrystalline silicon photoelectric conversion unit, a CIS photoelectric conversion unit, a CdTe photoelectric conversion unit, or the like in the form of a thin film.

It is also preferred that the solar cell module has a surface where the epoxy-modified polyolefin-based resin composition is not present. This is achieved by, for example, performing integral molding after resin sheets constituted from a glass non-woven fabric or the like are brought into close contact with the upper and lower surfaces of work. By doing so, it is possible to prevent the thickness of the module from varying from place to place, thereby preventing not only damage to the module due to a pressing pressure locally applied during integral molding but also blocking of the entry of sunlight into a solar cell.

It is also preferred that the epoxy-modified polyolefin-based resin composition is obtained by introducing epoxy groups by the graft reaction by melt-kneading 100 parts by weight of the polyolefin-based resin (a) with 1 to 5 parts by weight of the epoxy group-containing vinyl monomer (c) and 0 to 1 part by weight of the aromatic vinyl monomer (d) in the presence of 0.05 to 3 parts by weight of the radical polymerization initiator (b). In this case, epoxy groups are introduced in a preferred graft state such that sufficient adhesive properties are achieved without reduction in processability or degradation in performance required of a sealing material, such as water vapor barrier properties, due to the cleavage of the main chain of the polyolefin-based resin (a) by the radical polymerization initiator and without reduction in cushioning properties or shape conformability due to curing of the resin caused by excessive cross-linking induced by a hydrogen abstraction reaction. Therefore, the resin composition has excellent processability and sealing performance and preferably has high transparency.

It is also preferred that the solar cell sealing material is a sheet-shaped molded body obtained by subjecting the modified polyolefin resin composition to extrusion molding or calender roll molding, and is also a thermally-weldable sheet molded body not requiring post-crosslinking. As described above, the modified polyolefin resin composition according to the present invention has excellent processability, and therefore can be molded into a sheet by extrusion molding or calender roll molding. Further, the modified polyolefin resin composition according to the present invention does not require post-crosslinking after integral molding, that is, post cure after lamination which is required for EVA to ensure sealing properties. This makes it possible to produce the solar cell module with high productivity. The post-crosslinking includes not only heating treatment but also electron beam irradiation treatment or the like.

More specifically, the present invention includes a method for producing a thermally-weldable sheet molded body, including the step of extruding the melt-kneaded modified polyolefin resin composition into a sheet or a film and a method for producing a thermally-weldable sheet molded body, including the step of molding the modified polyolefin resin composition into a sheet or a film by calender roll molding.

It is also preferred that the solar cell sealing material has any one or more of the following characteristics (1), (2), and (3), more preferably the characteristics (1) and (2) or the characteristics (1) and (3), even more preferably all the characteristics (1) to (3). When having the characteristics (1) and (2), the solar cell sealing material is suitable as a material for sealing thin-film solar cells. When having the characteristics (1) and (3) or all the characteristics (1) to (3), the solar cell sealing material is suitable as a material for sealing crystalline solar cells.

(1) Water vapor barrier properties of less than 2 {(g/m²·day)/0.4 mm} are achieved.

(2) An adhesive strength of 80 N/10 mm width or more (180° peel test) is achieved by adhesion to glass at 170°C.

(3) A total light transmittance at 417 nm as measured by an integrating sphere method is 97% or more.

It is also preferred that the sheet molded body according to the present invention has surface irregularities (embossing or pearskin finish) whose arithmetic mean roughness (centerline average roughness) Ra is 0.001 to 0.2 mm. As described above, the modified polyolefin resin composition according to the present invention has excellent processability and excellent shape conformability, and therefore the sheet molded body can be subjected to such processing. Even when being subjected to such processing, the sheet molded body conforms to the surface profile of a solar cell and therefore the solar cell can be properly sealed. By allowing the sheet molded body to have such surface irregularities, it is possible to allow work and the sheet to slide against each other, thereby improving so-called blocking resistance. From the viewpoint of such blocking resistance and preventing the sealed module from suffering adverse effects that may be caused by the surface irregularities, such as local application of pressure to a solar cell and insufficient welding, the Ra of the surface irregularities is more preferably 0.002 to 0.1 mm, even more preferably 0.003 to 0.03 mm, particularly preferably 0.005 to 0.015 mm.

It is not always necessary to allow the entire surface of the sheet molded body according to the present invention to have such surface irregularities. From the viewpoint of improving visibility to efficiently perform alignment of the sheet, which is cloudy due to its surface irregularities, with work or the like, it is preferred that a transparent portion having no surface irregularities is partially left in a pattern.

It is also preferred that the epoxy-modified polyolefin-based resin composition contained in the solar cell sealing material has a multiple-phase structure in which a phase composed of the polyolefin-based resin (a) contains a phase composed of the epoxy group-containing vinyl monomer (c) and the aromatic vinyl monomer (d) and having an average diameter of 1 µm or less.

It is also preferred that the epoxy-modified polyolefin-based resin composition does not contain a silane coupling agent. This makes it possible to prevent fluctuations in the reliability of the solar cell module resulting from variations in the adhesive properties of the sealing material due to time degradation of coupling performance of a silane coupling agent, or to prevent degradation in the insulating performance or the appearance of the module resulting from bleedout of a silicon-containing processed material from the sealing material.

It is also preferred that the epoxy-modified polyolefin-based resin composition further contains 0.1 to 50 parts by weight of a tackifying resin.

The present invention also relates to a method for producing the solar cell module according to the present invention, including performing integral molding at 135°C or higher.

The present invention also relates to a method for recycling the solar cell sealing material removed from the solar cell module according to the present invention, including molding the solar cell sealing material into a sheet-shaped molded body. The solar cell sealing material removed from the solar cell module is preferably recycled or reused as the solar cell sealing material according to the present invention, but may be used as a thermally-weldable sheet for other applications.

It is also preferred that the epoxy-modified polyolefin-based resin composition contained in the solar cell sealing material is obtained by melt-kneading the polyolefin-based resin (a) with the epoxy group-containing vinyl monomer (c) and the aromatic vinyl monomer (d) in the presence of the radical polymerization initiator (b), wherein the amount of the epoxy group-containing vinyl monomer (c) is 0.1 to 50 wt% with respect to 100 wt% of the total of the polyolefin-based resin (a), the epoxy group-containing vinyl monomer (c), and the aromatic vinyl monomer (d).

It is also preferred that the epoxy modified polyolefin-based resin composition contained in the solar cell sealing material is obtained by melt-kneading the following (a) to (d) :
(a) polyolefin-based resin 100 parts by weight
(b) radical polymerization initiator 0.01 to 5 parts by weight
(c) epoxy group-containing vinyl monomer 0.01 to 20 parts by weight
(d) aromatic vinyl monomer 0 to 3 parts by weight.

It is also preferred that the polyolefin-based resin (a) used to obtain the solar cell sealing material is at least one selected from the group consisting of polyethylene, polypropylene, an ethylene-propylene copolymer (hereinafter, sometimes abbreviated as "EPCP" in this specification).

It is also preferred that the polyolefin-based resin (a) used to obtain the solar cell sealing material is LDPE, LLDPE, or a soft polypropylene-based resin.

It is also preferred that the polyolefin-based resin (a) is an ethylene-propylene copolymer (EPCP) whose ethylene content is 1 to 30 wt%. From the viewpoint of flexibility and transparency required of a sealing material and formation of the solar cell sealing material having a temperature range suitable for adhesion, the ethylene content of the ethylene-propylene copolymer is more preferably 5 to 30 wt%, even more preferably 5 to 15 wt%.

It is also preferred that the polyolefin-based resin (a) used to obtain the solar cell sealing material is a soft polypropylene-based resin whose heat of melting is 10 J/g or less.

It is also preferred that the epoxy group-containing vinyl monomer (c) used to obtain the solar cell sealing material is glycidyl methacrylate.

It is also preferred that the aromatic vinyl monomer (d) used to obtain the solar cell sealing material is styrene.

The present invention also relates to a method for producing the solar cell sealing material according to the present invention, including the step of producing a modified polyolefin resin composition, including in order the steps of: melt-kneading a polyolefin-based resin (a) and a radical polymerization initiator (b) to obtain a mixture of (a) and (b); and adding an epoxy group-containing vinyl monomer (c) to the mixture of (a) and (b) and melt-kneading them to obtain a mixture of (a), (b), and (c).

The solar cell sealing material according to the present invention has high water vapor barrier properties, and the use of the solar cell sealing material according to the present invention to seal solar cells makes it possible to achieve high productivity. Further, the solar cell sealing material according to the present invention preferably has excellent adhesive properties to adhesion-resistant base materials and transparency equivalent to that of EVA used to seal solar cells. Further, the solar cell sealing material according to the present invention is less likely to cause decomposition gas generation during sealing and hydrolysis-induced acid generation affecting long-term module reliability which are problems for EVA.

The solar cell sealing material according to the present invention preferably has excellent adhesive properties to adhesion-resistant base materials, especially glass, glass plates, and fluorine-based resin sheets, and is therefore a solar cell sealing material having high reliability.

The solar cell sealing material according to the present invention preferably has transparency (light transmittance) equivalent to that of EVA used to seal solar cells, and is therefore suitable as a material for sealing crystalline silicon solar cells, that is, as components 3A and 3B shown in Fig. 1. The solar cell sealing material according to the present invention is preferably used as the component 3A shown in Fig. 1, that is, as a light receiving suface-side sealing material.

The modified polyolefin resin composition according to the present invention may be used singly or as a compounding agent, and is appropriately used in various fields such as stationery, groceries, packaging materials for foods, automotive parts, home electrical appliances, electric and electronic parts such as solar cell sealing materials, and various industrial materials.

### Effects of the Invention

According to the present invention, it is possible to provide a high-performance and highly-reliable solar cell module sealed with a solar cell sealing material which allows solar cell quality to be maintained over a long period of time and which has excellent recyclability and module productivity.

### BRIEF DESCRIPTION OF THE DRAWINGS

Fig. 1 shows an example of a solar cell module according to the present invention.
Fig. 2 shows another example of the solar cell module according to the present invention.
Fig. 3 shows the dependence of adhesive forces of sheet samples of Example 30 and Comparative Example 17 on integral molding temperature.

### DESCRIPTION OF REFERENCE NUMERALS

- 1: Light-receiving surface-side transparent protective member
- 2: Back surface-side transparent protective member
- 3A: Light-receiving surface-side sealing material
- 3B: Back surface-side sealing material
- 4: Solar cell
- 5: End-face seal portion
- 6: Peripheral portion

### PREFERRED MODE FOR CARRYING OUT THE INVENTION

Hereinafter, the present invention will be described in detail.

### (Solar Cell Sealing Material)

A solar cell sealing material according to the present invention has excellent solar cell module productivity. This is because heat resistance is imparted to the solar cell sealing material according to the present invention by pseudo-crosslinking by the crystalline component of an olefin-based polymer during integral molding, and therefore the solar cell sealing material according to the present invention does not require post-crosslinking which a sealing material such as EVA requires. From the viewpoint of allowing the solar cell sealing material according to the present invention to have sufficient sealing properties and preferably to have transparency, the solar cell sealing material according to the present invention preferably contains the crystalline component in an amount such that the heat of melting of the solar cell sealing material according to the present invention as an indicator of its crystalline component content is preferably 150 J/g or less, more preferably 50 J/g or less, even more preferably 10 J/g or less but preferably 1 J/g or more or such that the crystallinity of the solar cell sealing material according to the present invention as determined by an X-ray method as an indicator of its crystalline component content is preferably 30% or less, more preferably 10% or less, even more preferably 5% or less but is preferably 1% or more.

Further, the solar cell sealing material according to the present invention is preferably obtained by molding a modified polyolefin-based resin composition according to the present invention by extrusion molding or calender roll molding. Therefore, the MFR of the solar cell sealing material according to the present invention as measured in accordance with JIS-K-7210 is preferably 8 or more, more preferably 20 or more. As the extrusion molding, extrusion molding using a T-die or an annular die can be mentioned.

Further, when the crystalline component content and MFR of the solar cell sealing material according to the present invention are within the above ranges, the solar cell sealing material according to the present invention preferably naturally has an embossed surface in some cases even when molded using not a die having a characteristic embossed surface but a die or rolls having a smooth surface. More preferably, the solar cell sealing material according to the present invention is a molded article obtained by calender roll molding. This tends to allow a wider range of resin compositions to naturally have an embossed surface.

It is preferred that the solar cell sealing material according to the present invention does not need undergo cross-linking treatment induced by exposure to ionizing radiation or by an organic peroxide after integral molding, that is, does not need to undergo post-crosslinking. More specifically, a radical polymerization initiator (b), which is typified by an organic peroxide and is preferably added to obtain the epoxy-modified polyolefin-based resin composition according to the present invention, is already inactive, preferably is not present after processing into the sealing material. Even when the radical polymerization initiator (b) is present in the sealing material, post-crosslinking does not occur because the sealing material is not subjected to a high-temperature process, such as kneading, after integral molding, or the solar cell sealing material does not require post-crosslinking itself. Further, post-crosslinking does not occur even by epoxy groups of the epoxy-modified polyolefin-based resin composition according to the present invention introduced by a graft reaction because a catalyst or the like is not particularly added, or the solar cell sealing material according to the present invention does not require post-crosslinking itself. The solar cell sealing material according to the present invention that does not require post-crosslinking is a preferred embodiment of the solar cell sealing material according to the present invention that can be recycled.

When the solar cell sealing material according to the present invention is dissolved in, for example, boiling p-xylene for 12 hours and then filtered through filter paper, the gel fraction ratio (i.e., the ratio of the weight of an insoluble part of a material subjected to dissolution to the total weight of the material) of the solar cell sealing material according to the present invention is preferably 5% or less, more preferably less than 1%. It is considered that such an insoluble part, that is, a gel fraction has a three-dimensional structure formed by cross-linking. The solar cell sealing material according to the present invention has physical properties required for sealing without such a three-dimensionally-crosslinked part due to pseudo-crosslinking achieved by the above-described crystalline component, and is preferably recyclable.

The solar cell sealing material according to the present invention is composed of the epoxy-modified polyolefin-based resin composition according to the present invention having the above-described characteristics, and is therefore a highly-dimensionally-stabilized material whose heat shrinkage ratio at 60°C is preferably 10% or less. If necessary, the solar cell sealing material according to the present invention may be subjected to annealing to further reduce its heat shrinkage ratio.

The solar cell sealing material according to the present invention is composed of the epoxy-modified polyolefin-based resin composition according to the present invention having the above-described characteristics, and is therefore excellent in creep resistance, weather resistance, and heat shock resistance. Further, the solar cell sealing material according to the present invention contains substantially no active peroxide that may produce gas during integral molding, and is therefore less likely to cause a problem that a back sheet is bulged during integral molding.

### (Additive)

If necessary, the solar cell sealing material according to the present invention or the modified polyolefin resin composition according to the present invention may contain an additive without impairing the effects of the present invention. Examples of the additive include stabilizers such as antioxidants, metal deactivators, phosphorus-based processing stabilizers, ultraviolet absorbers, ultraviolet stabilizers, fluorescent whiteners, metallic soaps, antacid adsorbents, radical scavengers, and moisture scavengers, cross-linking agents, chain transfer agents, nucleating agents, lubricants, plasticizers, filling materials, reinforcing materials, pigments, dyes, flame retardants, and antistatic agents.

Examples of the radical scavengers include phenol-based scavengers, phosphorus-based scavengers, sulfur-based scavengers, and HALS-based scavengers. The radical scavenger content of the resin composition according to the present invention is preferably 0 to 3 mass%.

Examples of the moisture scavengers include alkaline-earth metal oxides, sulfates, and silicates. Among them, zeolite is preferred. The moisture scavenger content of the resin composition according to the present invention is preferably 0 to 20 mass%.

### (Epoxy-Modified Polyolefin-Based Resin Composition)

The epoxy-modified polyolefin-based resin composition used in the present invention, which is obtained by introducing an epoxy group-containing monomer by a graft reaction, is not particularly limited as long as it is obtained by introducing an epoxy group-containing compound by a graft reaction. Examples of such an epoxy-modified polyolefin-based resin composition include glycidyl methacrylate-modified polyolefins.

The present inventors have found that, unlike acidic functional groups whose presence reduces water vapor barrier properties, the presence of epoxy groups does not reduce water vapor barrier properties and the epoxy-modified polyolefin-based resin composition has very high adhesive properties, especially adhesive properties to glass. Such high adhesive properties to glass achieved by the present invention has been found by determining the adhesion of the epoxy-modified polyolefin-based resin composition according to the present invention to an end-face seal portion (which will be described later), especially to the end face of a glass plate by integral molding. This effect allows a solar cell module according to the present invention to have high reliability, high cushioning properties, and high heat shock resistance and to be produced with high productivity at low cost.

### (Containing no Silane Coupling Agent)

The epoxy-modified polyolefin-based resin composition according to the present invention contains no silane coupling agent which makes it difficult to maintain the reliability of a solar cell module due to its temporal change and which may lead to a reduction in yield. Therefore, the use of the solar cell sealing material according to the present invention makes it possible to produce a highly-reliable solar cell module with high yield.

### (Polyolefin-Based Resin)

Examples of a polyolefin-based resin (a) used in the present invention include: polypropylene homopolymers; high-density polyethylene; low-density polyethylene; linear low-density polyethylene; poly-1-butene; polyisobutylene; random and block copolymers of various ratios of propylene and ethylene and/or 1-butene; ethylene-propylene-diene terpolymers of various ratios of ethylene and propylene and 50 wt% or less of a diene component; polymethylpentene; cyclic polyolefins such as copolymers of cyclopentadiene and ethylene and/or propylene; random copolymers of ethylene or propylene and 50 wt% or less of a vinyl compound such as vinyl acetate, alkyl methacrylate, alkyl acrylate, or aromatic vinyl; polyolefin-based thermoplastic elastomer block copolymers; and olefin-based thermoplastic elastomers (simple mixtures of polypropylene and an ethylene/propylene copolymer or an ethylene-propylene-diene terpolymer, partially-crosslinked products thereof, or completely-crosslinked products thereof). These resins may be used singly or in combination of two or more of them.

Specific examples of the polyolefin resin (a) include: homopolyolefins; LLDPE that is low density polyethylene obtained by copolymerizing ethylene and an α-olefin (e.g., propylene, butene, hexene, octene, 4-methylpentene) to introduce short-chain branches; ethylene-propylene copolymers (EPCP); ethylene-butene copolymers (hereinafter, sometimes abbreviated as "EBCP" in this specification); ethylene-propylene-diene terpolymers; cyclic polyolefins; and ethylene-propylene-vinyl terpolymers. From the viewpoint of obtaining a composition having excellent physical properties at low cost, at least one selected from the group consisting of polyethylene, polypropylene, ethylene-propylene copolymers (EPCP), and ethylene-butene copolymers (EBCP) is preferred, LDPE, LLDPE, and ethylene-propylene copolymers (EPCP), each of which will be described later, are more preferred, LDPE, LLDPE, soft polypropylene-based resins including ethylene-propylene copolymers (EPCP), and ethylene-butene copolymers (EBCP) are even more preferred, and LLDPE and ethylene-propylene copolymers (EPCP) are particularly preferred.

Examples of the homopolyolefins include polyethylene (low-density polyethylene (LDPE), high-density polyethylene (HDPE)), polypropylene, poly-1-butene, polyisobutylene, and polymethylpentene. Among them, polyethylene and polypropylene are preferred and LDPE is more preferred because they can be produced on an industrial scale at low cost.

Examples of the ethylene-propylene copolymers (EPCP) include random or block copolymers of various ratios of ethylene, propylene, and if necessary, at least one selected from the group consisting of 1-butene, 1-hexene, and 1-octene. Among them, random copolymers obtained by copolymerizing only ethylene and propylene are preferred.

Examples of the ethylene-butene copolymers (EBCP) include random or block copolymers of various ratios of ethylene, 1-butene, and if necessary, at least one selected from the group consisting of 1-hexene and 1-octene.

Examples of the ethylene-propylene-diene terpolymers include ternary copolymers of various ratios of ethylene and propylene and 50 wt% or less of a diene component.

Examples of the cyclic polyolefins include copolymers of cyclopentadiene and ethylene and/or propylene.

Examples of the ethylene-propylene-vinyl terpolymers include ternary random or block copolymers of various ratios of ethylene and propylene and 50 wt% or less of a vinyl component.

Among them, polyethylene, polypropylene, poly-1-butene, and random or block copolymers of propylene and ethylene and/or 1-butene are preferred. Particularly, at least one selected from the group consisting of polyethylene, polypropylene, and ethylene-propylene copolymers (EPCP) is preferred. From the viewpoint of flexibility and transparency required of a sealing material, the ethylene content of the ethylene-propylene copolymers (EPCP) is preferably 1 to 30 wt%, more preferably 5 to 30 wt%, particularly preferably 5 to 15 wt%. If the polypropylene content is too high, a temperature range suitable for adhesion tends to be high.

In other words, among them, polyethylene, polypropylene, and polyisobutylene are preferred, polyethylene and polypropylene are more preferred, LDPE, LLDPE and soft polypropylene-based resins are even more preferred, and soft polypropylene-based resins whose heat of melting is 10 J/g or less, for example, ethylene-propylene copolymers (EPCP) such as Versify manufactured by Dow Chemical Company are particularly preferred.

As the soft polypropylene-based resins, ethylene propylene rubbers (EPR) may be used instead of the ethylene-propylene copolymers (EPCP). EPR refers to a mixture of polyethylene and polypropylene generally called block type (e.g., PRIME TPO manufactured by Prime Polymer Co., Ltd., Catalloy (reactor TPO) manufactured by SunAllomer Ltd.).

From the viewpoint of ensuring softness and laminate processability required of a solar cell sealing material, the ethylene content of the ethylene-propylene copolymers (EPCP) is preferably 1 to 30 wt%, more preferably 5 to 30 wt%, even more preferably 5 to 15 wt%.

From the viewpoint of transparency, LLDPE is preferred as polyethylene and the α-olefin contained as a comonomer preferably has a long chain, and TPO obtained by copolymerization with ethylene is preferred as polypropylene.

Further, a polyolefin resin having polar groups introduced thereinto can also be used from the viewpoint of high compatibility with an unsaturated carboxylic acid monomer having a polar group. Specific examples of the polyolefin resin having polar groups introduced thereinto include: acid-modified polypropylenes such as maleic anhydride-modified polypropylenes, maleic acid-modified polypropylenes, and acrylic acid-modified polypropylenes; ethylene or α-olefin/vinyl monomer copolymers such as ethylene/vinyl chloride copolymers, ethylene/vinylidene chloride copolymers, ethylene/acrylonitrile copolymers, ethylene/methacrylonitrile copolymers, ethylene/vinyl acetate copolymers, ethylene/acrylamide copolymers, ethylene/methacrylamide copolymers, ethylene/acrylic acid copolymers, ethylene/methacrylic acid copolymers, ethylene/maleic acid copolymers, ethylene/methyl acrylate copolymers, ethylene/ethyl acrylate copolymers, ethylene/isopropyl acrylate copolymers, ethylene/butyl acrylate copolymers, ethylene/isobutyl acrylate copolymers, ethylene/2-ethylhexyl acrylate copolymers, ethylene/methyl methacrylate copolymers, ethylene/ethyl methacrylate copolymers, ethylene/isopropyl methacrylate copolymers, ethylene/butyl methacrylate copolymers, ethylene/isobutyl methacrylate copolymers, ethylene/2-ethylhexyl methacrylate copolymers, ethylene/maleic anhydride copolymers, ethylene/ethyl acrylate/maleic anhydride copolymers, ethylene/acrylic acid metal salt copolymers, ethylene/methacrylic acid metal salt copolymers, ethylene/vinyl acetate copolymers or saponified products thereof, ethylene/vinyl propionate copolymers, ethylene/glycidyl methacrylate copolymers, ethylene/ethyl acrylate/glycidyl methacrylate copolymers, and ethylene/vinyl acetate/glycidyl methacrylate copolymers; and chlorinated polyolefins such as chlorinated polypropylene and chlorinated polyethylene. These polyolefins having polar groups introduced thereinto may be used in combination of two or more of them.

From the viewpoint of industrial-scale production at low cost, polypropylene and polyethylene are preferred.

From the viewpoint of transparency, ethylene/methacrylic acid metal salt copolymers and ethylene/vinyl acetate copolymers are preferred. If necessary, another resin or rubber may be added to the raw material polyolefin resin without impairing the effects of the present invention.

If necessary, another resin or rubber may be added to the raw material polyolefin resin without impairing the effects of the present invention.

Examples of the another resin and the rubber include: polyethylene; poly α-olefins such as polypropylene, polybutene-1, polyisobutene, polypentene-1, and polymethylpentene-1; ethylene or α-olefin/a-olefin copolymers such as ethylene/propylene copolymers with a propylene content of less than 75 wt%, ethylene/butene-1 copolymers, and propylene/butene-1 copolymers with a propylene content of less than 75 wt%; ethylene or α-olefin/α-olefin/diene-based monomer copolymers such as ethylene/propylene/5-ethylidene-2-norbornene copolymers with a propylene content of less than 75 wt%; polydiene-based copolymers such as polybutadiene and polyisoprene; vinyl monomer/diene-based monomer random copolymers such as styrene/butadiene random copolymers; vinyl monomer/diene-based monomer/vinyl monomer block copolymers such as styrene/butadiene/styrene block copolymers; hydrogenated(vinyl monomer/diene-based monomer random copolymers) such as hydrogenated(styrene/butadiene random copolymers); hydrogenated(vinyl monomer/diene-based monomer/vinyl monomer block copolymers) such as hydrogenated(styrene/butadiene/styrene block copolymers); vinyl monomer/diene-based monomer/vinyl monomer graft copolymers such as acrylonitrile/butadiene/styrene graft copolymers and methyl methacrylate/butadiene/styrene graft copolymers; vinyl polymers such as polyvinyl chloride, polyvinylidene chloride, polyacrylonitrile, polyvinyl acetate, polyethyl acrylate, polybutyl acrylate, polymethyl methacrylate, and polystyrene; and vinyl-based copolymers such as vinyl chloride/acrylonitrile copolymers, vinyl chloride/vinyl acetate copolymers, acrylonitrile/styrene copolymers, and methyl methacrylate/styrene copolymers.

The amount of the another resin or the rubber to be added to the polyolefin-based resin (a) according to the present invention varies depending on the type of resin or rubber used, and, as described above, is not particularly limited as long as the effects of the present invention are not impaired. However, the amount of the another resin or the rubber to be added to the polyolefin-based resin (a) according to the present invention is usually preferably about 25 wt% or less. Addition of rubber is preferred from the viewpoint of improving the shock resistance of the solar cell module.

These polyolefin resins (which sometimes contain any additive) may be in the form of particles or pellets, and the size and shape thereof are not particularly limited.

When the above-described added material (another resin, rubber, stabilizer and/or additive) is used, the added material may be added to the polyolefin resin in advance, or may be added when the polyolefin resin is melted, or may be added to an epoxy-modified polyolefin-based resin composition by an appropriate method after production of the epoxy-modified polyolefin-based resin composition.

### (Epoxy Group-Containing Vinyl Monomer)

Examples of an epoxy group-containing vinyl monomer (c) used in the present invention include glycidyl methacrylate, glycidyl acrylate, monoglycidyl maleate, diglycidyl maleate, monoglycidyl itaconate, diglycidyl itaconate, monoglycidyl allylsuccinate, diglycidyl allylsuccinate, glycidyl p-styrene carboxylate, allyl glycidyl ether, methallyl glycidyl ether, styrene-p-glycidyl ether, p-glycidyl styrene, epoxy olefins such as 3,4-epoxy-1-butene and 3,4-epoxy-3-methyl-1-butene, and vinylcyclohexene monoxide. These epoxy group-containing vinyl monomers may be used singly or in combination of two or more of them.

Among them, glycidyl methacrylate and glycidyl acrylate are preferred because they are inexpensive, and glycidyl methacrylate is particularly preferred.

The amount of the epoxy group-containing vinyl monomer (c) to be added is preferably 0.1 to 100 parts by weight, more preferably 0.5 to 50 parts by weight, even more preferably 1 to 15 parts by weight, even more preferably 1 to 10 parts by weight, particularly preferably 1 to 5 parts by weight with respect to 100 parts by weight of the polyolefin-based resin (a). Further, the amount of the epoxy group-containing vinyl monomer (c) is preferably in the range of 0.1 to 50 wt%, more preferably in the range of 0.5 to 40 wt%, particularly preferably in the range of 1 to 30 wt% with respect to 100 wt% of the total of the polyolefin-based resin (a), the epoxy-group-containing vinyl monomer (c), and an aromatic vinyl monomer (d). If the amount of the epoxy group-containing vinyl monomer (c) to be added is too small, adhesive properties tend not to be sufficiently improved. On the other hand, if the amount of the epoxy group-containing vinyl monomer (c) to be added is too large, the obtained resin composition tends not to have an appropriate shape or appearance.

### (Aromatic Vinyl Monomer)

The modified polyolefin resin composition according to the present invention is a resin composition obtained by melt-kneading the polyolefin resin (a) with the epoxy group-containing vinyl monomer (c). If necessary, the aromatic vinyl monomer (d) may be added.

Examples of the aromatic vinyl monomer (d) used in the present invention include: styrene; methylstyrenes such as O-methylstyrene, m-methylstyrene, p-methylstyrene, α-methylstyrene, β-methylstyrene, dimethylstyrene, and trimethylstyrene; chlorostyrenes such as o-chlorostyrene, m-chlorostyrene, p-chlorostyrene, α-chlorostyrene, β-chlorostyrene, dichlorostyrene, and trichlorostyrene; bromostyrenes such as o-bromostyrene, m-bromostyrene, p-bromostyrene, dibromostyrene, and tribromostyrene; fluorostyrenes such as o-fluorostyrene, m-fluorostyrene, p-fluorostyrene, difluorostyrene, and trifluorostyrene; nitrostyrenes such as o-nitrostyrene, m-nitrostyrene, p-nitrostyrene, dinitrostyrene, and trinitrostyrene; vinylphenols such as o-hydroxystyrene, m-hydroxystyrene, p-hydroxystyrene, dihydroxystyrene, and trihydroxystyrene; divinylstyrenes such as o-divinylstyrene, m-divinylstyrene, and p-divinylstyrene; and diisopropenylbenzenes such as o-diisopropenylbenzene, m-diisopropenylbenzene, and p-diisopropenylbenzene. Among them, styrene, methylstyrenes such as α-methylstyrene and p-methylstyrene, divinylbenzene monomers, and divinylbenzene isomer mixtures are preferred because they are inexpensive, and styrene is particularly preferred. The above-mentioned aromatic vinyl monomers may be used singly or in combination of two or more of them.

The amount of the aromatic vinyl monomer (d) to be added is preferably 50 parts by weight or less, more preferably 30 parts by weight with respect to 100 parts by weight of the polyolefin-based resin (a). From the viewpoint of preventing a reduction in transparency due to the formation of large domains of a copolymer with the epoxy group-containing vinyl monomer (c), the amount of the aromatic vinyl monomer (d) to be added is even more preferably 3 parts by weight or less. In order to improve adhesive properties to glass or to maintain transparency, the amount of the aromatic vinyl monomer (d) to be added is even more preferably 1 part by weight or less, particularly preferably 0.5 part by weight or less.

The amount of the aromatic vinyl monomer (d) to be added may be 0 part by weight with respect to 100 parts by weight of the polyolefin-based resin (a). However, from the viewpoint of preventing degradation in sealing performance due to a reduction in molecular weight caused by cleavage of the main chain of the polyolefin-based resin (a) by the radical polymerization initiator (b) according to the present invention during melt-kneading according to the present invention or from the viewpoint of preventing degradation in molding processability during molding into a sheet or film according to the present invention due to a reduction in viscosity, that is, from the viewpoint of radical stabilization achieved by the aromatic vinyl monomer (d), the amount of the aromatic vinyl monomer (d) to be added is preferably 0.01 part by weight or more, more preferably 0.1 part by weight or more.

This is because when the amount of the aromatic vinyl monomer (d) to be added is within the above range, the grafting efficiency of the epoxy group-containing vinyl monomer (c) onto the polyolefin-based resin can be kept at a high level. On the other hand, if the amount of the aromatic vinyl monomer (d) to be added is too large, the grafting efficiency of the epoxy group-containing vinyl monomer reaches a saturated level, and therefore the upper limit of the amount of the aromatic vinyl monomer (d) to be added is preferably 50 parts by weight.

### (Radical Initiator)

The radical polymerization initiator (b) is added to initiate a reaction to graft-copolymerize the epoxy group-containing vinyl monomer (c) onto the polyolefin resin (a).

Examples of the radical initiator (b) generally used in the present invention include peroxides and azo compounds.

Examples of the radical polymerization initiator include organic peroxides such as ketone peroxides (e.g., methyl ethyl ketone peroxide and methyl acetoacetate peroxide); peroxy ketals (e.g., 1,1-bis(t-butylperoxy)-3,3,5-trimethylcyclohexane, 1,1-bis(t-butylperoxy)cyclohexane, n-butyl-4,4-bis(t-butylperoxy)valerate, and 2,2-bis(t-butylperoxy)butane); hydroperoxides (e.g., permethane hydroperoxide, 1,1,3,3-tetramethylbutyl hydroperoxide, diisopropylbenzene hydroperoxide, and cumene hydroperoxide); dialkyl peroxides (e.g., dicumyl peroxide, 2,5-dimethyl-2,5-di(t-butylperoxy)hexane, α,α'-bis(t-butylperoxy-m-isopropyl)benzene, t-butylcumyl peroxide, di-t-butylperoxide, and 2,5-dimethyl-2,5-di(t-butylperoxy)hexyne-3); diacyl peroxides such as benzoyl peroxide; peroxy dicarbonates such as di(3-methyl-3-methoxybutyl)peroxy dicarbonate and di-2-methoxybutyl peroxydicarbonate; and peroxy esters (e.g., t-butyl peroxyoctate, t-butyl peroxyisobutylate, t-butyl peroxylaurate, t-butyl peroxy-3,5,5-trimethyl hexanoate, t-butyl peroxyisopropyl carbonate, 2,5-dimethyl-2,5-di(benzoylperoxy)hexane, t-butyl peroxyacetate, t-butyl peroxybenzoate, and di-t-butyl peroxy isophthalate). These radical polymerization initiators may be used singly or in combination of two or more of them.

Among them, those having a high ability to abstract a hydrogen atom are particularly preferred. Examples of such radical polymerization initiators include: peroxy ketals such as 1,1-bis(t-butylperoxy)-3,3,5-trimethylcyclohexane, 1,1-bis(t-butylperoxy)cyclohexane, n-butyl-4,4-bis(t-butylperoxy)valerate, and 2,2-bis(t-butylperoxy)butane; dialkyl peroxides such as dicumyl peroxide, 2,5-dimethyl-2,5-di(t-butylperoxy)hexane, α,α'-bis(t-butylperoxy-m-isopropyl)benzene, t-butylcumyl peroxide, di-t-butylperoxide, and 2,5-dimethyl-2,5-di(t-butylperoxy)hexyne-3; diacyl peroxides such as benzoyl peroxide; and peroxy esters such as t-butyl peroxyoctate, t-butyl peroxyisobutylate, t-butyl peroxylaurate, t-butyl peroxy-3,5,5-trimethyl hexanoate, t-butyl peroxyisopropyl carbonate, 2,5-dimethyl-2,5-di(benzoylperoxy)hexane, t-butyl peroxyacetate, t-butyl peroxybenzoate, and di-t-butyl peroxy isophthalate. These radical polymerization initiators may be used singly or in combination of two or more of them.

The amount of the radical polymerization initiator (b) to be added is preferably in the range of 0.01 to 10 parts by weight, more preferably in the range of 0.01 to 5 parts by weight, even more preferably in the range of 0.05 to 3 parts by weight, even more preferably in the range of 0.1 to 1 part by weight, particularly preferably in the range of 0.2 to 0.7 part by weight with respect to 100 parts by weight of the polyolefin-based resin. Here, when the polyolefin-based resin (a) according to the present invention is LDPE or LLDPE, the amount of the radical polymerization initiator (b) to be added is most preferably 0.25 to 0.5 part by weight, and when the polyolefin-based resin (a) according to the present invention is an ethylene-propylene copolymer (EPCP), the amount of the radical polymerization initiator (b) to be added is most preferably 0.3 to 0.7 part by weight. If the amount of the radical polymerization initiator to be added is less than 0.01 part by weight, modification does not properly proceed. On the other hand, if the amount of the radical polymerization initiator to be added exceeds 10 parts by weight, the fluidity and mechanical properties of the polyolefin are reduced.

### (Tackifier)

A tackifying resin, that is, a tackifier used in the present invention is not particularly limited. Examples of the tackifier include: rosin-based resins (e.g., gum rosin, tall-oil rosin, wood rosin, hydrogenated rosin, disproportionated rosin, polymerized rosin, maleated rosin, rosin glycerin ester, and hydrogenated rosin-glycerin ester); terpene phenol resins; terpene resins (e.g., α-pinene resin, β-pinene resin, and dipentene resin); aromatic hydrocarbon-modified terpene resins; petroleum resins (e.g., aliphatic, alicyclic, and aromatic petroleum resins); coumarone-indene resins; styrene-based resins (e.g., styrene-based resins and substituted styrene-based resins); phenol-based resins (e.g., alkyl phenol resins and rosin-modified phenol resins); and xylene resins. These resins may be used singly or in combination of two or more of them.

As the tackifying resins used in the present invention, terpene-based resins are preferred. Among them, at least one selected from the group consisting of terpene phenol resins and hydrogenated terpene resins is more preferred from the viewpoint of excellent compatibility and high heat resistance, and hydrogenated terpene phenol resins are even more preferred from the viewpoint of ensuring transparency. Among terpene phenol-based resins, those having a softening point of 20°C to 200°C and a number average molecular weight (Mn) of 300 to 1200 are particularly preferred from the viewpoint of improving compatibility and tackiness.

Specific examples of the hydrogenated terpene resins include Clearon P manufactured by Yasuhara Chemical Co., Ltd. (hydrogenated dipentene resin, nonpolar, Clearon P-105) and Clearon K manufactured by Yasuhara Chemical Co., Ltd. (hydrogenated aromatic modified terpene resin, polar, Clearon K-4100).

Specific examples of the hydrogenated terpene phenol resins include YS Polystar TH130 and YS Polystar UH115 manufactured by Yasuhara Chemical Co., Ltd.

When the tackifying resin is used in the present invention, the amount of the tackifying resin to be added is not particularly limited. However, the amount of the tackifying resin to be added is preferably 0.1 to 50 parts by weight, more preferably 0.1 to 30 parts by weight, even more preferably 0.3 to 20 parts by weight, and particularly preferably 0.5 to 10 parts by weight with respect to 100 parts by weight of the polyolefin-based resin and the epoxy-modified polyolefin-based resin composition.

### (Modified Polyolefin Resin Composition)

The modified polyolefin resin composition according to the present invention is a resin composition obtained by grafting a graft chain composed of the epoxy group-containing vinyl monomer (c) onto the polyolefin resin (a). From the viewpoint of enhancing grafting efficiency, the modified polyolefin resin composition according to the present invention is preferably a resin composition obtained by grafting a graft chain composed of the epoxy group-containing vinyl monomer (c) and the aromatic vinyl monomer (d) onto the polyolefin resin (a).

A graft polymerization reaction used in the present invention is not particularly limited, and solution polymerization, impregnation polymerization, melt polymerization, or the like can be used. Particularly, melt polymerization is preferred because it is easy and simple. The order and method of addition during melt-kneading are not particularly limited. It is to be noted that the order and method of mixing and melt-kneading of other materials added if necessary are not particularly limited. The heating temperature during melt-kneading is preferably 100 to 250°C from the viewpoint of sufficiently melting the polyolefin resin without thermal decomposition. The melt-kneading time (i.e., time after addition of the radical polymerization initiator) is usually 30 seconds to 60 minutes.

Examples of an apparatus used for the melt-kneading include extruders, banbury mixers, mills, kneaders, and heating rolls. From the viewpoint of productivity, single or twin screw extruders are preferably used. In order to sufficiently and uniformly mix various materials, the melt-kneading may be repeated two or more times.

The order and method of addition during melt-kneading are preferably as follows: the polyolefin-based resin and the radical polymerization initiator are melt-kneaded to obtain a mixture and then the epoxy group-containing vinyl monomer and the aromatic vinyl monomer are added to the mixture and melt-kneaded. Such order of addition makes it possible to suppress the generation of a low-molecular weight component that does not contribute to graft polymerization. It is to be noted that the order and method of mixing and melt-kneading of other materials added if necessary are not particularly limited.

The heating temperature during melt-kneading is preferably 130 to 300°C from the viewpoint of sufficiently melting the polyolefin-based resin without thermal decomposition. The melt-kneading time (i.e., time after addition of the radical polymerization initiator) is usually 30 seconds to 60 minutes.

Examples of an apparatus used for the melt-kneading include extruders, banbury mixers, mills, kneaders, and heating rolls. From the viewpoint of productivity, single or twin screw extruders are preferably used. In order to sufficiently and uniformly mix various materials, the melt-kneading may be repeated two or more times.

The epoxy-modified polyolefin-based resin composition according to the present invention is particularly effective when it has a multiple-phase structure in which a phase composed of the epoxy group-containing vinyl monomer (c) and the aromatic vinyl monomer (d) is finely dispersed in a phase composed of the polyolefin-based resin. Depending on reaction conditions such as heating temperature and melt-kneading time, the average diameter of the phase composed of the epoxy group-containing vinyl monomer and the aromatic vinyl monomer contained in the phase composed of the polyolefin-based resin is preferably 1 µm or less, more preferably 0.5 µm or less, particularly preferably 0.3 µm or less. In this case, the phase composed of the epoxy group-containing vinyl monomer is finely dispersed, and therefore the adhesive properties and gas barrier properties of the epoxy-modified polyolefin-based resin composition can be efficiently improved.

### (Use as Additive)

When the epoxy-modified polyolefin-based resin composition according to the present invention is added as an additive to a polyolefin-based resin, the adhesive properties of the polyolefin-based resin can be improved.

Examples of such a polyolefin-based resin, to which the epoxy-modified polyolefin-based resin composition according to the present invention is added, include: polypropylene homopolymers; high-density polyethylene; low-density polyethylene; linear low-density polyethylene; poly-1-butene; polyisobutylene; random and block copolymers of various ratios of propylene and ethylene and/or 1-butene; ethylene-propylene-diene terpolymers of various ratios of ethylene and propylene and 50 wt% or less of a diene component; polymethylpentene; cyclic polyolefins such as copolymers of cyclopentadiene and ethylene and/or propylene, random copolymers of ethylene or propylene and 50 wt% or less of a vinyl compound such as vinyl acetate, alkyl methacrylate, alkyl acrylate, or aromatic vinyl; polyolefin-based thermoplastic elastomer block copolymers; and olefin-based thermoplastic elastomers (simple mixtures of polypropylene and an ethylene/propylene copolymer or an ethylene-propylene-diene terpolymer, partially-crosslinked products thereof, or completely-crosslinked products thereof). These resins may be used singly or in combination of two or more of them.

Among them, polypropylene homopolymers are preferred from the viewpoint of high stiffness and low price, and block copolymers of propylene and another monomer are preferred from the viewpoint of high stiffness and high shock resistance. When flexibility is required, polyolefin-based thermoplastic elastomers are preferred.

When the epoxy-modified polyolefin-based resin composition according to the present invention is added to a polyolefin-based resin, the amount of the epoxy-modified polyolefin-based resin composition according to the present invention to be added is not particularly limited, but is preferably 0.1 to 100 parts by weight, more preferably 0.1 to 70 parts by weight, even more preferably 0.3 to 50 parts by weight, even more preferably 0.5 to 20 parts by weight with respect to 100 parts by weight of the polyolefin-based resin. If the amount of the epoxy-modified polyolefin-based resin composition according to the present invention to be added is less than the above lower limit, the epoxy-modified polyolefin-based resin composition according to the present invention tends to be ineffective in reforming the polyolefin-based resin. On the other hand, if the amount of the epoxy-modified polyolefin-based resin composition according to the present invention exceeds the above upper limit, there is a case where the intrinsic mechanical properties of the polyolefin-based resin are reduced and economic problems arise.

### (Sheet- or Film-Shaped Molded Body)

The modified polyolefin resin composition according to the present invention can be molded into a thermally-weldable polyolefin sheet or film. Further, a polyolefin resin composition obtained by mixing a polyolefin resin and the modified polyolefin resin composition according to the present invention can also be molded into a thermally-weldable polyolefin sheet or film. The term "thermally-weldable" in the present invention refers to the ability to be thermally melted and bonded to an adherend.

The sealing material containing the epoxy-modified polyolefin-based resin composition according to the present invention can be supplied as a sheet- or film-shaped molded body. The thickness of the molded body is, for example, 3 µm or more, 10 µm or more, 10 mm or less, or 3 mm or less, but is preferably 10 µm to 5 mm. From the viewpoint of handleability and imparting insulating properties, the thickness of the molded body is more preferably 100 µm to 1 mm, even more preferably 150 µm to 500 µm.

A method for producing a sheet-shaped molded body of the epoxy-modified polyolefin-based resin composition according to the present invention is not particularly limited. For example, the epoxy-modified polyolefin-based resin composition according to the present invention and another compounding agent are dry-blended and melt-kneaded and then molded into a sheet-shaped molded body with the use of any molding machine such as an extruder, an injection molding machine, a calender roll molding machine, an inflation molding machine, a roll molding machine, or a hot-press molding machine.

From the viewpoint of the quality of the obtained sheet and productivity, the method for producing the sheet- or film-shaped molded body according to the present invention is preferably at least one selected from the group consisting of the above-described extrusion molding method using an extruder and the above-described calender roll molding method using a calender roll molding machine. In the case of the extrusion molding method, extrusion molding using a T-die is more preferred. In the case of the calender roll molding method, the epoxy-modified polyolefin-based resin composition according to the present invention having a melt flow rate (MFR) of 1 to 100 as measured in accordance with JIS-K-7210 is preferably used. From the viewpoint of the quality of the obtained sheet, productivity, and stable production, the melt flow rate is preferably 8 or more, more preferably 20 or more. In this case, the polyolefin-based resin (a) according to the present invention is more preferably an ethylene-propylene copolymer (EPCP).

### (Solar Cell Module)

A solar cell module according to the present invention can be obtained by sealing a solar cell provided between a light-receiving surface-side transparent protective member and a back surface-side protective member with a sealing sheet composed of the epoxy-modified polyolefin-based resin composition according to the present invention. A method for properly sealing a solar cell to produce such a solar cell module is roughly divided into two types depending on whether the solar cell is a crystalline solar cell or an amorphous solar cell. In the case of a crystalline solar cell, as shown in Fig. 1, a light-receiving surface-side transparent protective member 1, a light-receiving surface-side sealing material 3A, a solar cell 4, a back surface-side sealing material 3B, and a back surface-side protective member 2 are stacked and integrally molded using a vacuum laminator. In the case of an amorphous solar cell, as shown in Fig. 2, a light-receiving surface-side transparent protective member 1, a solar cell 4 (which is in contact with the light-receiving surface-side transparent protective member), a back surface-side sealing material 3B, and a back surface protective member 2 are stacked and integrally molded using a vacuum laminator. The integral molding using a vacuum laminator is performed by thermocompression bonding under conditions of a temperature of 135 to 250°C, preferably 135 to 220°C, more preferably 135 to 210°C, even more preferably 135 to 180°C, even more preferably 140 to 180°C, particularly preferably 155 to 180°C, a deaeration time of 0.1 to 5 minutes, a pressing pressure of 0.1 to 1.5 kg/cm², and a pressing time of 5 to 15 minutes.

The solar cell sealing material according to the present invention is not decomposed even at high temperature unlike EVA, and exhibits sufficient adhesive properties by integral molding even at low temperature. Therefore, the solar cell sealing material according to the present invention can be used to seal both a solar cell whose solar cell characteristics are further improved by high-temperature treatment and a solar cell whose solar cell characteristics are deteriorated by high-temperature treatment, that is, the solar cell sealing material according to the present invention can be used in a wide temperature range to seal various types of solar cells. For example, the solar cell sealing material according to the present invention can be used to seal solar cells whose solar cell characteristics are improved by high-temperature treatment performed at 200°C or higher at which EVA is decomposed.

By the application of heat and pressure under such conditions as described above, the light-receiving surface-side transparent protective member 1, the back surface-side transparent member 2, and the solar cell 4 are brought into close contact with each other and integrated by the sealing sheet(s) composed of the epoxy-modified polyolefin resin composition used as the light-receiving surface-side sealing material 3A and/or the back surface-side sealing material 3B so that the solar cell 4 is sealed. The use of the sealing material according to the present invention in a solar cell having such a structure as described above makes it possible to suppress degradation in the power generation performance of a solar cell which is a problem caused by acid generated from a conventional sealing material due to the entry of moisture during long-term use, thereby allowing the solar cell to have high durability.

The light-receiving surface-side transparent protective member used in the present invention is a member used in the form of film, sheet, or plate. As the light-receiving surface-side transparent protective member, a plate made of silicate glass or polycarbonate and having both strength suitable for practical use and transparency is usually used, and a glass substrate is particularly preferably used. The thickness of the glass substrate is usually 0.1 to 10 mm, preferably 0.3 to 5 mm. The glass substrate may be usually reinforced chemically or thermally.

The back surface protective member used in the present invention is a member used in the form of film, sheet, or plate. As the back surface protective member, glass, aluminum foil, or a laminate of plastic films is preferably used. Examples of a resin used in the plastic films include, but are not limited to, polyvinyl fluoride, polyethylene terephthalate, polyethylene naphthalate, polyethylene, and tetrafluoroethylene-ethylene copolymers. The back surface protective member is generally called "back sheet" and constituted from a single layer or a laminate combining heat resistance, moisture resistance, weather resistance, and insulating properties.

It is to be noted that, as described above, the solar cell according to the present invention is characterized by the sealing material used on the light-receiving surface side and/or on the back surface side. Therefore, the members other than the sealing material, such as the light-receiving surface-side transparent protective member, the back surface-side protective member, and the solar cell, are not particularly limited as long as the solar cell according to the present invention has the same structure as a conventionally-known solar cell.

### (Other Usages)

An adherend to be used in the present invention is made of, for example, a material that can be adhered to an adhesive resin layer of the adhesive film according to the present invention. Specific examples of such a material include: metals such as gold, silver, copper, iron, tin, lead, aluminum, and silicon; inorganic materials such as glass and ceramics; cellulose-based polymer materials such as paper and fabrics; and synthetic polymer materials such as melamine resins, acrylic urethane resins, urethane resins, (meth)acrylic resins, styrene·acrylonitrile copolymers, polycarbonate resins, phenol resins, polyester resins, epoxy resins, and silicon resins.

The material of the adherend may be obtained by mixing or combining two or more different materials. When two different adherends are bonded to each other using the adhesive film according to the present invention interposed therebetween to obtain a laminate, materials constituting the two adherends may be the same or different from each other. The properties of the adherend are not particularly limited, but the adherend may be in the form of, for example, film, sheet, plate, or fiber. If necessary, the adherend may be subjected to surface treatment or the like such as coating with a release agent, plating, coating with paint, surface modification with plasma or laser, surface oxidation, or etching. Specific examples of the adherend include, but are not limited to, automotive parts such as roof materials, outer walls, trims (e.g., door trims and interior trims), molded headers, and sheet materials (e.g., interior sheets, instrument panel cover sheets, and decorative sheets) and decorative films used in housing materials such as interior doors, partitions, interior wall panels, furniture, and kitchen units.

### EXAMPLES

Hereinbelow, the present invention will be described with reference to specific examples, but is not limited to the following examples. In the following examples and comparative examples, "part(s)" and "%" refer to "part(s) by weight" and "% by weight", respectively.

### (Grain Size Measurement)

Grain size was determined by observation with a transmission-type electron microscope and calculation. JEM-1200EX manufactured by JEOL Ltd. was used as the transmission-type electron microscope and operated at an acceleration voltage of 80 kV. It is to be noted that a sample was prepared by ruthenium oxide staining and ultrathin frozen sectioning.

### (Adhesive Property Evaluation)

A solar cell sealing sheet composed of the epoxy-modified polyolefin-based resin composition according to the present invention having a width of 50 mm and a length of 50 mm was interposed between a solar cell amorphous substrate (i.e., a power-generating element obtained by processing silicon etc. vapor-deposited on glass) having a width of 50 mm and a length of 100 mm and a back sheet (icosolar s/s 2116 manufactured by ISOVOLTA Inc.) having a width of 50 mm and a length of 100 mm, and they were integrally molded using a vacuum laminator (Spi-Laminator manufactured by Spire Corporation). The integral molding was performed by thermocompression bonding under conditions of a temperature of 170°C, a deaeration time of 3.5 minutes, a pressing pressure of 1 kg/cm², and a pressing time of 3.5 minutes to obtain a test sample.

When a test sample was prepared using an EVA-based resin as a sealing material, the test sample was further heated in an oven at 150°C for 120 minutes to cross-link EVA.

Adhesive property evaluation was made using AG-2000A manufactured by Shimadzu Corporation in the following manner. The amorphous substrate and the back sheet were held with upper and lower chucks, respectively and were subjected to a tensile test at a test speed of 50 mm/min at 23°C to measure maximum strength. Adhesive properties were evaluated according to the following criteria.
A: The maximum strength was 1 kgf/cm or more.
B: The maximum strength was less than 1 kgf/cm.

### (Evaluations of Heat Resistance and Moisture Resistance of Solar Cell Module)

A solar cell sealing sheet composed of the epoxy-modified polyolefin-based resin composition according to the present invention having a width of 6 inches and a length of 6 inches was interposed between a solar cell amorphous substrate (i.e., a power-generating element obtained by processing silicon etc. vapor-deposited on a glass plate) measuring 5 inches long and 5 inches wide, that is, a thin-film solar cell and a back sheet (icosolar s/s 2116 manufactured by ISOVOLTA Inc.) measuring 5 inches long and 5 inches wide, and they were integrally molded using a vacuum laminator (Spi-Laminator manufactured by Spire Corporation). The integral molding was performed by thermocompression bonding under conditions of a temperature of 170°C, a deaeration time of 3.5 minutes, a pressing pressure of 1 kg/cm², and a pressing time of 3.5 minutes to obtain a solar cell module. When a solar cell module was obtained using an EVA-based resin as a sealing material, the solar cell module was further heated in an oven at 150°C for 120 minutes to cross-link EVA.

Here, when a solar cell module was produced using EVA, module end faces including a module end face orthogonal to a panel surface were further sealed with a thermoplastic butyl resin. When a solar cell module was produced using a sheet sample composed of the epoxy-modified polyolefin resin according to the present invention, the sealing resin in a module peripheral portion parallel to a panel surface was, of course, left as it was and the sealing resin with a thickness of about 1 mm adhered to the glass plate on a module end face orthogonal to the glass plate, that is, to the panel surface was also left as it was.

The adhesion of the sealing material to the panel surface of the module did not occur because the integral molding was performed after resin sheets were brought into close contact with the upper and lower surfaces of work.

The thus produced solar cell module was irradiated with artificial sunlight with an irradiation intensity of 1000 mW/cm² at 25°C with the use of a solar simulator whose spectrum was adjusted to AM 1.5 to measure the open circuit voltage (V), nominal maximum power current per 1 cm² (A), and nominal maximum power voltage per 1 cm² (V) of the solar cell. The product of the nominal maximum power current and the nominal maximum power voltage was determined as the initial value of nominal maximum power (W) (JIS C8911 1998).

Then, the solar cell module was allowed to stand for 200 hours under conditions of a temperature of 85°C and a humidity of 85%RH to perform a heat and moisture resistance test. After the solar cell module was allowed to stand for 200 hours, the nominal maximum power (W) of the solar cell module was determined in the same manner as described above to evaluate the heat resistance and moisture resistance of the solar cell module according to the following criteria.
A: A value obtained by dividing the nominal maximum power determined after the 200-hour heat and moisture resistance test by the initial value was 0.95 or more.
B: A value obtained by dividing the nominal maximum power determined after the 200-hour heat and moisture resistance test by the initial value was less than 0.95.

Further, in each of the following Comparative Example 1 and Example 3, a sample produced by integral molding at 200°C using the EVA sheet or the sheet sample was also prepared in addition to a sample produced by integral molding at 170°C. These samples were subjected to the heat and moisture resistance test for 450 hours and 1000 hours to determine the retention of power with respect to the initial value. It is to be noted that, in this case, the back sheet used to prepare these samples was TOYAL SOLAR FA20/AL30/BPET50/LE50 manufactured by Toyo Aluminum K.K.

### (Evaluation of Recyclability)

After the adhesive property evaluation, only the sealing material was removed from the test sample and pulverized. The recyclability of the sealing material was evaluated whether the pulverized sealing material was able to be molded into a sheet by hot press (10 kgf/cm²) at 200°C for 1 minute.
A: The pulverized sealing material was able to be molded into a sheet.
B: The pulverized sealing material was not able to be molded into a sheet.

### (Example 1)

90 parts by weight of an ethylene-propylene copolymer (EPCP) (a) (Versify 3401.05 manufactured by Dow Chemical Company, MFR=8, random copolymer with a weight ratio (propylene:ethylene) of 85:15) and 0.52 part by weight of 1,3-di (t-butylperoxyisopropyl) benzene (b) (PERBUTYL P manufactured by NOF Corporation, one-minute half value period temperature: 175°C) were supplied to a twin screw extruder (TEX30 manufactured by The Japan Steel Works Ltd., L/D=28) set to 200°C and were melt-kneaded. Then, 5 parts by weight of glycidyl methacrylate (c) and 5 parts by weight of styrene (d) were added in the middle of a cylinder of the extruder and melt-kneaded to obtain epoxy-modified polyolefin-based resin composition pellets (A-1). The thus obtained epoxy-modified polyolefin-based resin composition pellets (A-1) were hot-pressed using a spacer having a thickness of 0.40 mm at 200°C and 10 kgf/cm² for 5 minutes and cooled to obtain a solar cell sealing sheet (A-11) having a thickness of 0.40 mm. As a result of grain size measurement, the average grain size of domains composed of glycidyl methacrylate and styrene components in (A-11) was 0.12 µm. The results of evaluations of adhesive properties, heat resistance and moisture resistance, and recyclability are shown in Table 1.

**Table 1**

| | Example 1 | Example 2 | Comparative Example 1 | Comparative Example 2 |
|---|---|---|---|---|
| Polyolefin or Resin | Modified EPCP | Modified PP:EPCP =34:50 | EVA | EPCP |
| Adhesive Property Evaluation | A | A | A | B |
| Evaluations of Heat Resistance and Moisture Resistance | A | A | A | B |
| Recyclability Evaluation | A | A | B | A |

### (Example 2)

34 parts by weight of random polypropylene PP (a-1) (J229E manufactured by Prime Polymer Co. Ltd., MFR=50), 50 parts by weight of an ethylene-propylene copolymer (EPCP) (a-2) (V3401 manufactured by Dow Chemical Company, MFR=8), and 1.5 parts by weight of 1,3-di(t-butylperoxyisopropyl)benzene (PERBUTYL P manufactured by NOF Corporation, one-minute half value period temperature: 175°C) were supplied to a twin screw extruder (TEX30 manufactured by The Japan Steel Works Ltd., L/D=28) set to 200°C and were melt-kneaded. Then, 8.0 parts by weight of glycidyl methacrylate (c) and 8.0 parts by weight of styrene (d) were added in the middle of a cylinder of the extruder and melt-kneaded to obtain epoxy-modified polyolefin-based resin composition pellets (A-2). The resin pellets contain ethylene and propylene in a ratio of 9:91 in terms of monomer.

The thus obtained epoxy-modified polyolefin-based resin composition pellets (A-2) were hot-pressed using a spacer having a thickness of 0.40 mm at 200°C and 10 kgf/cm² for 5 minutes and then cooled to obtain a solar cell sealing sheet (A-12) having a thickness of 0.40 mm. As a result of grain size measurement, the average grain size of domains composed of glycidyl methacrylate and styrene components in (A-12) was 0.15 µm. The results of evaluations of adhesive properties, heat resistance and moisture resistance, and recyclability are shown in Table 1.

### (Comparative Example 1)

A test sample for adhesive property evaluation and a solar cell module were produced using a commercially-available solar cell sealing EVA sheet (Ultra Pearl manufactured by SANVIC INC., thickness: 0.40 mm). The results of evaluations of adhesive properties, heat resistance and moisture resistance, and recyclability are shown in Table 1.

Further, in the above-described "Evaluations of Heat Resistance and Moisture Resistance of Solar Cell Module", a sample of Comparative Example 1-1 was prepared by integral molding at 170°C and a sample of Comparative Example 1-2 was prepared by integral molding at 200°C to determine their retention rate. In the case of Comparative Example 1-2, the retention rate determined after 450-hour incubation was less than 20%, and therefore the test was not continued to 1000 hours. The results are shown in Table 2.

As a result of a comparison between the results of Comparative Example 1-1 and the results of Comparative Example 1-2, the retention rate of the sample of Comparative Example 1-2 prepared by integral molding at 200°C was significantly reduced. From the result, it has been found that EVA is decomposed due to exposure to high temperature and therefore does not offer sufficient sealing performance. Further, in the case of Comparative Example 1-2, an odor thought to be caused by generation of decomposition gas was detected during integral molding. Further, it can be considered that the solar cell of this sample whose retention rate was low was not properly sealed and therefore damaged due to hydrolysis caused by the entry of moisture. It can also be considered that, in the worst case, the back sheet is bulged by decomposition gas generated from EVA and therefore has a poor appearance even before reliability degradation becomes a problem.

**Table 2**

| Sample | Resin | Integral Molding Temperature (°C) | Retention Rate (%) | |
|---|---|---|---|---|
| | | | Test Time (hr.) | |
| | | | 450 | 1000 |
| Comparative Example 1-1 | EVA | 170 | 83 | 49 |
| Comparative Example 1-2 | EVA | 200 | 19 | |
| Example 3-1 | LDPE | 170 | 102 | 93 |
| Example 3-2 | LDPE | 200 | 98 | 96 |

### (Comparative Example 2)

Polyethylene propylene rubber pellets (a) (V3401 manufactured by Dow Chemical Company, MFR=8) were hot-pressed using a spacer having a thickness of 0.40 mm at 200°C and 10 kgf/cm² for 5 minutes and then cooled to obtain a solar cell sealing sheet having a thickness of 0.40 mm. The results of evaluations of adhesive properties, heat resistance and moisture resistance, and recyclability are shown in Table 1.

### (Example 3)

100 parts by weight of low-density polyethylene (LDPE) (a) (MIRASON manufactured by Du Pont-Mitsui Polychemicals Co. Ltd., MFR=4.8) and 0.5 part by weight of 1,3-di(t-butylperoxyisopropyl) benzene (b) (PERBUTYL P manufactured by NOF Corporation, one-minute half value period temperature: 175°C) were supplied to a vent-equipped twin screw extruder (manufactured by The Japan Steel Works Ltd. under the trade name of TEX44, 40 mmφ, L/D=38), whose cylinder temperature was set to 200°C and screw rotation rate was set to 150 rpm, to start melt-kneading. Then, 5 parts by weight of glycidyl methacrylate (c) and 5 parts by weight of styrene (d) were added in the middle of a cylinder of the extruder and melt-kneaded to obtain modified polyethylene resin pellets. 100 parts by weight of the thus obtained modified resin pellets and 10 parts by weight of a terpene phenol resin (YS Polystar T130 manufactured by Yasuhara Chemical Co., Ltd.) were charged into a hopper of a single screw extruder (manufactured by Toyo Seiki Seisaku-sho, Ltd. under the trade name of Laboplastomill, 20 mmφ, L/D=20), whose cylinder temperature and die temperature were set to 200°C and screw rotation rate was set to 100 rpm, and then extruded through a T-die attached to the end of a die to obtain a sheet sample having a width of about 13 cm and a thickness of 0.4 mm.

Further, in the above-described "Evaluations of Heat Resistance and Moisture Resistance of Solar Cell Module", a sample of Example 3-1 was prepared by integral molding at 170°C and a sample of Example 3-2 was prepared by integral molding at 200°C to determine their retention rate. The results are shown in Table 2.

Here, the retention rate of the sample of Example 3-1 determined after 450-hour incubation was 102%, that is, the nominal maximum power of the sample of Example 3-1 determined after 450-hour incubation was larger than its initial value. It is considered that this indicates that the conversion efficiency of a solar cell may be improved by high-temperature treatment at about 200°C, that is, by annealing for the reason of, for example, stabilization of metallization.

A comparison between the results of Example 3-1 and the results of Example 3-2 shows that there was not a large difference in retention rate between the sample of Example 3-1 and the sample of Example 3-2 and both the samples achieved a sufficiently high retention rate. However, the sample obtained by integral molding at 200°C achieved a slightly higher retention rate.

As a result of a comparison between the results of Example 3 and the results of Comparative Example 1, it has been found that, unlike EVA, even when integral molding is performed at 200°C at which annealing effects can be obtained, the solar cell sealing material according to the present invention offers sufficient sealing performance without generating decomposition gas and without causing hydrolysis.

Further, LDPE is generally inexpensive, and the fact that the use of such an inexpensive material as a main ingredient makes it possible to seal thin film solar cells, which are generally thought to be sensitive to humidity, over a long period of time is a remarkable effect. This indicates that epoxy-modified LDPE or a sealing material obtained by adding a tackifier to it is particularly suitable as a material for sealing thin-film solar cells, that is, as the material of the component 3B shown in Fig. 2.

Hereinbelow, the present invention will be described in more detail with reference to the following examples and comparative examples.

### (Ra Measurement Method)

A 3 cm x 3 cm sample for measuring Ra was cut out from substantially the center of a sheet sample. Then, Ra was measured at any five points on the surface of the sheet sample, each of which covered a measurement area of 110 µm × 150 µm, with the use of a laser microscope VK-8500 manufactured by KEYENCE Corporation in accordance with JIS-B0601-1994. The average of measurements was determined.

### (Conditions of Integral Molding)

In the following description of this specification, integral molding was performed under the following conditions: deaeration was performed at 170°C for 3.5 minutes and then thermocompression bonding was performed at 170°C and a pressing pressure of 1 kg/cm² for a pressing time of 10 minutes.

When an EVA-based resin sheet was used as a sheet sample, integral molding (thermocompression bonding) was performed under the above conditions, and then heating in an oven at 150°C was further performed for 120 minutes to cross-link EVA.

In the case of sealing with EVA, heating at 150°C for 120 minutes is necessary to cross-link EVA to allow EVA to exhibit physical properties required of a solar cell sealing material in a solar cell module.

### (Adhesive Properties to Back Sheet)

In the following description of this specification, an adhesive strength test sample was prepared in the following manner. A glass plate (manufactured by Nippon Sheet Glass Company, thickness: 5 mm), a sheet sample which will be described later, and a solar cell sealing back sheet (TOYAL SOLAR FA20/AL30/BPET50/LE50 manufactured by Toyo Aluminum K.K.) were integrally molded by pressure bonding using a vacuum laminator (LM-50x50-S manufactured by NPC Incorporated).

The thus prepared adhesive strength test sample was evaluated as to whether the back sheet was adhered to or peeled off from the sheet sample. The evaluation results are shown in columns labeled "Adhesive Properties to Back Sheet" in Tables 3, 4, and 5.

### (Adhesive Strength to Glass)

Adhesive strength to glass was measured in the following manner. Two slits were made using a cutter in the adhesive strength test sample from the solar cell sealing back sheet to the glass plate to cut out a strip having a width of 10 mm. Then, a 180° peel test was performed by pulling the glass plate and the sheet sample of the strip away from each other from one of the ends of the strip along the interface between them at a test speed of 50 mm/min at 23°C with the use of AG-2000A manufactured by Shimadzu Corporation. A force required to pull the glass plate and the sheet sample away from each other was measured.

### (Water Vapor Barrier Properties)

The moisture transmission rate of a sheet sample having a thickness of 0.4 mm was measured in units of {(g/m²·day)/0.4 mm) in accordance with JIS K7126-1 (differential pressure method) under conditions of 40°C/90%RH, a permeation area of 15.2 cm², and a pressure difference of 75 cmHg. A lower moisture transmission rate indicates higher water vapor barrier properties.

### (Evaluation of Adhesive Properties of Thin-Film Solar Cell Module)

In the following description of this specification, a thin-film solar cell module was obtained in the following manner. A sheet sample of the solar cell sealing sheet according to the present invention (which will be described later) having a width of 50 mm and a length of 50 mm was interposed between a thin-film solar cell (i.e., a hybrid-type power-generating element obtained by processing silicon etc. vapor-deposited on a glass substrate) measuring 5 inches long and 5 inches wide and a back sheet (TOYAL SOLAR FA20/AL30/BPET50/LE50 manufactured by Toyo Aluminum K.K.) measuring 5 inches long and 5 inches wide, and then they were integrally molded using a vacuum laminator (Spi-Laminator manufactured by Spire Corporation).

When a sheet composed of the modified-polyolefin resin composition according to the present invention was used as a sheet sample, the integral molding was performed under the following conditions: deaeration was performed at 170°C for 3.5 minutes and then thermocompression bonding was performed at a pressing pressure of 1 kg/cm² for a pressing time of 10 minutes.

Here, when a solar cell module was produced using EVA, module end faces including a module end face orthogonal to a panel surface were further sealed with a thermoplastic butyl resin. When a solar cell module was produced using a sheet sample composed of the epoxy-modified polyolefin resin according to the present invention, the sealing resin in a module peripheral portion parallel to the panel surface was, of course, left as it was and the sealing resin with a thickness of about 1 mm adhered to the glass plate on a module end face orthogonal to the glass plate, that is, to the panel surface was also left as it was.

The adhesion of the sealing material to the panel surface of the module did not occur because the integral molding was performed after resin sheets were brought into close contact with the upper and lower surfaces of work.

### (Sensory Evaluation of Peeling Properties)

In the following description of this specification, a sensory evaluation of adhesive properties was performed in the following manner. The end of the obtained module was held and the back sheet and the sealing material were peeled off from the solar cell substrate to evaluate adhesive properties according to the following criteria.
A: The sealing material was not able to be peeled off from the solar cell substrate at all.
B: The sealing material was able to be slightly (2 to 3 cm) peeled off from the solar cell substrate in the end of the module.
C: The sealing material was able to be slightly (2 to 3 cm) peeled off from the solar cell substrate in the end of the module, and was also peeled off from the back sheet.
D: The sealing material was peeled off from both the back sheet and the solar cell substrate.

### (Transparency of Resin)

A test sample was prepared in the following manner. A transparent slide glass (manufactured by Matsunami Glass Ind., Ltd., thickness: 0.9 mm), a sheet sample (thickness: 400 µm), and a transparent slide glass (manufactured by Matsunami Glass Ind., Ltd., thickness: 0.9 mm) were integrally molded using a vacuum laminator (LM-50x50-S manufactured by NPC Incorporated).

The total light transmittance of the thus prepared test sample was measured by a spectrophotometer (V-560 manufactured by JASCO Corporation, integrating sphere method). A comparison was made based on the transmittance at 417 nm at which the transmittance of the EVA sheet begins to decrease.

### (Transparency of Crystalline Solar Cell Module and Visual Sensory Evaluation)

A crystalline Si solar cell element measuring 5 inches long and 5 inches wide was interposed between sheet samples of the solar cell sealing sheet according to the present invention measuring 6 inches long and 6 inches wide, and a back sheet (manufactured by Isovolta Inc., PVF/PET/PVF) was stacked on one of the sheet samples and a glass plate (manufactured by Nippon Sheet Glass Company, thickness: 3.2 mm) was stacked on the other sheet sample, and then they were integrally molded using a vacuum laminator (Spi-Laminator manufactured by Spire Corporation) to obtain a crystalline silicon solar cell module.

Here, when a solar cell module was produced using EVA, module end faces including a module end face orthogonal to a panel surface were further sealed with a thermoplastic butyl resin. When a solar cell module was produced using sheet samples composed of the epoxy-modified polyolefin resin according to the present invention, the sealing resin in a module peripheral portion parallel to a panel surface was, of course, left as it was and the sealing resin with a thickness of about 1 mm adhered to the glass plate on a module end face orthogonal to the glass plate, that is, to the panel surface was also left as it was.

The adhesion of the sealing material to the panel surface of the module did not occur because the integral molding was performed after resin sheets were brought into close contact with the upper and lower surfaces of work.

The appearance of the obtained module was observed to determine how the solar cell was able to be seen through glass, and a sensory evaluation was performed according to the following criteria.
A: The sealing material layers were colorless and transparent and therefore the solar cell was clearly visible.
B: The sealing material layers were slightly cloudy, but the solar cell was visible.
C: The sealing material layers were slightly colored, but the solar cell was visible.
D: The sealing material layers were like opaque glass, and therefore the solar cell was not clearly visible.

### (Example 11)

100 parts by weight of linear low-density polyethylene (LLDPE) (a) (Evolue P manufactured by Prime Polymer Co., Ltd., SP90100) and 0.25 part by weight of 1,3-di(t-butylperoxyisopropyl) benzene (b) (PERBUTYL P manufactured by NOF Corporation, one-minute half value period temperature: 175°C) were supplied to a vent-equipped twin screw extruder (manufactured by The Japan Steel Works Ltd. under the trade name of TEX44, 40 mmφ, L/D=38), whose cylinder temperature was set to 200°C and screw rotation rate was set to 150 rpm, to start melt-kneading. Then, 10 parts by weight of glycidyl methacrylate (c) was added in the middle of a cylinder of the extruder and the components (a) to (c) were melt-kneaded to obtain modified polyethylene resin pellets.

The thus obtained modified-resin pellets were charged into a hopper of a single screw extruder (manufactured by Toyo Seiki Seisaku-sho, Ltd. under the trade name of Laboplastomill, 20 mmφ, L/D=20), whose cylinder temperature and die temperature were set to 200°C and screw rotation rate was set to 100 rpm, and then extruded through a T-die attached to the end of a die to obtain a sheet sample having a width of about 13 cm and a thickness of 0.4 mm. The processability was excellent without problems such as drawdown. The total light transmittance at 417 nm of the sheet sample was 99%.

The adhesive strength of the sheet sample was measured in such a manner as described above in "Adhesive Strength to Glass" and was found to be 104 N/10 mm width. Further, the water vapor barrier properties of the sheet sample were measured in such a manner as described above in "Water Vapor Barrier Properties", and as a result the moisture transmission rate of the sheet sample was 0.7 {(g/m²·day) /0.4 mm}. A thin-film solar cell module was produced in such a manner as described above using this sheet sample, and as a result, the sheet sample exhibited excellent adhesive properties. Further, a crystalline solar cell module was produced, and as a result, had an excellent appearance. The evaluation results are shown in Table 3.

**Table 3**

| | Example 11 | Example 12 | Example 13 | Example 14 |
|---|---|---|---|---|
| Polyolefin | LLDPE | LLDPE | EPCP | EBCP |
| Radical Initiator | 0.25 | 0.25 | 0.5 | 0.25 |
| Glycidyl Methacrylate | 10 | 9 | 10 | 10 |
| Styrene | 0 | 1 | 0 | 0 |
| Transparency | 99 | 98 | 99 | 99 |
| Adhesive Properties to Glass | 104 | 93 | 103 | - |
| Adhesive Properties to Back Sheet | Adhered | Adhered | Adhered | - |
| Water Vapor Barrier Properties | 0.7 | 0.7 | 1.5 | 1.5 |
| Processing Time | 13.5 min | 13.5 min | 13.5 min | 13.5 min |
| Sensory Evaluation of Peeling Properties of Thin-Film Solar Cell Module | A | A | A | - |
| Visual Sensory Evaluation of Crystalline Solar Cell Module | A | A | A | A |

| | Comparative Example 11 | Comparative Example 12 | Example 23 | Example 24 |
|---|---|---|---|---|
| Polyolefin | LLDPE | EPCP | LLDPE | EPCP |
| Radical Initiator | - | - | 0.25 | 0.5 |
| Glycidyl Methacrylate | - | - | 5 | 5 |
| Styrene | - | - | 5 | 5 |
| Transparency | - | - | 93 | 85 |
| Adhesive Properties to Glass | 0 | 0 | 41 | 13 |
| Adhesive Properties to Back Sheet | Peeled off | Peeled off | Adhered | Peeled off |
| Water Vapor Barrier Properties | 0.7 | 1.5 | 0.7 | 1.5 |
| Processing Time | 13.5 min | 13.5 min | 13.5 min | 13.5 min |
| Sensory Evaluation of Peeling Properties of Thin-Film Solar Cell Module | D | D | B | C |
| Visual Sensory Evaluation of Crystalline Solar Cell Module | - | - | B | B |

### (Example 12)

A sheet sample of Example 12 was obtained in the same manner as in Example 11 except that the amount of glycidyl methacrylate (c) added was changed to 9 parts by weight and 1 part by weight of styrene (d) was further added. As a result, the processability was excellent without problems such as drawdown. The total light transmittance at 417 nm of the sheet sample was 98%.

This sheet sample of Example 12 was evaluated in the same manner as in Example 11, and as a result, the adhesive strength to glass was 93 N/10 mm width and the moisture transmission rate was 0.7 {(g/m²·day)/0.4 mm}. A thin-film solar cell module was produced in such a manner as described above using this sheet sample, and as a result, the sheet sample exhibited excellent adhesive properties. Further, a crystalline solar cell module was produced, and as a result, had an excellent appearance. The evaluation results are shown in Table 3.

### (Example 13)

Modified resin pellets of Example 13 were obtained in the same manner as in Example 11 except that 100 parts by weight of an ethylene-propylene copolymer (EPCP) (a) (Versify 3401.05 manufactured by Dow Chemical Company, MFR=8, random copolymer with a weight ratio (propylene:ethylene) of 85:15) was used instead of LLDPE (a) and the amount of 1,3-di(t-butylperoxyisopropyl) benzene (b) (PERBUTYL P manufactured by NOF Corporation, one-minute half value period temperature: 175°C) was increased to 0.5 part by weight, and then a sheet sample of Example 13 was obtained in the same manner as in Example 11. As a result, the processability was excellent without problems such as drawdown. The total light transmittance at 417 nm of the sheet sample was 99%.

This sheet sample of Example 13 was evaluated in the same manner as in Example 11, and as a result, the adhesive strength to glass was 103 N/10 mm width and the moisture transmission rate was 1.5 {(g/m²·day)/0.4 mm}. A thin-film solar cell module was produced in such a manner as described above using this sheet sample, and as a result, the sheet sample exhibited excellent adhesive properties. Further, a crystalline solar cell module was produced, and as a result, had an excellent appearance. The evaluation results are shown in Table 3.

### (Example 14)

Modified resin pellets of Example 14 were obtained in the same manner as in Example 11 except that 100 parts by weight of an ethylene-butene copolymer (EBCP) (a) (TAFMER A4085S manufactured by Mitsui Chemicals Inc.) was used instead of LLDPE (a), and then a sheet sample of Example 14 was obtained in the same manner as in Example 11. As a result, the processability was excellent without problems such as drawdown. The total light transmittance at 417 nm of the sheet sample was 99%.

This sheet sample of Example 14 was evaluated in the same manner as in Example 11, and as a result, the moisture transmission rate was 1.5 {(g/m²·day)/0.4 mm}. A crystalline solar cell module was produced using this sheet sample, and as a result, had an excellent appearance. The evaluation results are shown in Table 3.

### (Comparative Example 11)

A sheet sample of Comparative Example 11 was obtained in the same manner as in Example 11 except that the components (b) and (c) were not used, and thus resin pellets of LLDPE (Evolue P manufactured by Prime Polymer Co., Ltd., SP90100) without modification treatment was used. As a result, the processability was excellent without problems such as drawdown.

This sheet sample of Comparative Example 11 was evaluated in the same manner as in Example 11, and as a result, the adhesive strength to glass was 0 N/10 mm width, that is, the sheet sample was not adhesive, and the moisture transmission rate was 0.7 {(g/m²·day)/0.4 mm}. An attempt was made to produce a solar cell module in such a manner as described above using this sheet sample, but this sheet sample was not adhered to the substrate and the back sheet, and therefore a solar cell module was not able to be produced. The evaluation results are shown in Table 3.

### (Comparative Example 12)

A sheet sample of Comparative Example 12 was obtained in the same manner as in Example 13 except that the components (b) and (c) were not used, and thus resin pellets of an ethylene-propylene copolymer (EPCP) (Versify 3401.05 manufactured by Dow Chemical Company) without modification treatment was used. As a result, the processability was excellent without problems such as drawdown.

This sheet sample of Comparative Example 12 was evaluated in the same manner as in Example 11, and as a result, the adhesive strength to glass was 0 N/10 mm width, that is, the sheet sample was not adhesive, and the moisture transmission rate was 1.5 {(g/m²·day)/0.4 mm}. An attempt was made to produce a solar cell module in such a manner as described above using this sheet sample, but this sheet sample was not adhered to the substrate and the back sheet, and therefore a solar cell module was not able to be produced. The evaluation results are shown in Table 3.

### (Example 23)

A sheet sample of Example 23 was obtained in the same manner as in Example 11 except that the amount of glycidyl methacrylate (c) added was changed to 5 parts by weight and 5 parts by weight of styrene (d) was further added. As a result, the processability was excellent without problems such as drawdown. The total light transmittance at 417 nm of the sheet sample was 93%.

This sheet sample of Example 23 was evaluated in the same manner as in Example 11, and as a result, the adhesive strength to glass was 41 N/10 mm width and the moisture transmission rate was 0.7 {(g/m²·day)/0.4 mm}. A thin-film solar cell module was produced in such a manner as described above using this sheet sample, and as a result, the sheet sample was able to be slightly peeled off from the solar cell substrate in the end of the module. Further, a crystalline solar cell module was produced in such a manner as described above, and as a result the sealing material layers were slightly cloudy. The evaluation results are shown in Table 3.

### (Example 24)

Modified resin pellets of Example 24 were obtained in the same manner as in Example 13 except that the amount of glycidyl methacrylate (c) added was changed to 5 parts by weight and 5 parts by weight of styrene (d) was further added, and then a sheet sample of Example 24 was obtained in the same manner as in Example 11. As a result, the processability was excellent without problems such as drawdown. The total light transmittance at 417 nm of the sheet sample was 85%.

This sheet sample of Example 24 was evaluated in the same manner as in Example 11, and as a result, the adhesive strength to glass was 13 N/10 mm width and the moisture transmission rate was 1.5 {(g/m²·day)/0.4 mm}. A thin-film solar cell module was produced in such a manner as described above using this sheet sample, and as a result, the sheet sample was able to be slightly peeled off from the solar cell substrate in the end of the module and was peeled off also from the back sheet. Further, a crystalline solar cell module was produced in such a manner as described above, and as a result, the sealing material layers were slightly cloudy. The evaluation results are shown in Table 3.

### (Comparative Example 15)

A sheet sample of Comparative Example 15 was obtained in the same manner as in Example 11 except that the components (b) and (c) were not used, and thus resin pellets of maleic anhydride-modified polypropylene (Admer QE060 manufactured by Mitsui Chemicals Inc.) was used. As a result, the processability was excellent without problems such as drawdown. The total light transmittance at 417 nm of the sheet sample was 92%.

This sheet sample of Comparative Example 15 was evaluated in the same manner as in Example 11, and as a result, the adhesive strength to glass was 60 N/10 mm width, the back sheet was peeled off during the peel test, and the moisture transmission rate was 2.5 {(g/m²·day)/0.4 mm}. A thin-film solar cell module was produced in such a manner as described above using this sheet sample, and as a result, the sheet sample was able to be slightly peeled off from the solar cell substrate in the end of the module and was peeled off also from the back sheet. Further, a crystalline solar cell module was produced using this sheet sample, and as a result, the sealing material layers were cloudy like opaque glass, and therefore the crystalline solar cell inside the module was not clearly visible. The evaluation results are shown in Table 4.

**Table 4**

| | Comparative Example 15 | Comparative Example 16 | Comparative Example 17 |
|---|---|---|---|
| Resin | Maleic Anhydride-Modified PP QE060 | Ethylene-GMA Copolymer Bond Fast-E | Ethylene-Vinyl Acetate Copolymer |
| Transparency | 92 | 96 | 99 |
| Adhesive Properties to Glass | 60 | 65 | 80 |
| Adhesive Properties to Back Sheet | Peeled off | Adhered | Adhered |
| Water Vapor Barrier Properties | 2.5 | 10 | 15 |
| Processing Time | 13.5 min | 13.5 min | 13.5 min + 2 hr |
| Sensory Evaluation of Peeling Properties of Thin-Film Solar Cell Module | c | B | A |
| Visual Sensory Evaluation of Crystalline Solar Cell Module | D | B | A |

### (Comparative Example 16)

A sheet sample of Comparative Example 16 was obtained in the same manner as in Example 11 except that the components (b) and (c) were not used, and thus resin pellets of an ethylene-glycidyl methacrylate copolymer (Bond Fast-E manufactured by Sumitomo Chemical Co., Ltd.) was used. As a result, the processability was excellent without problems such as drawdown. The total light transmittance at 417 nm of the sheet sample was 96%.

This sheet sample of Comparative Example 16 was evaluated in the same manner as in Example 11, and as a result, the adhesive strength to glass was 65 N/10 mm width and the moisture transmission rate was 10 {(g/m²·day)/0.4 mm}. A thin-film solar cell module was produced in such a manner as described above using this sheet sample, and as a result, the sheet sample was able to be slightly peeled off from the solar cell substrate in the end of the module. Further, a thin-film solar cell module was produced in such a manner as described above using this sheet sample, and as a result, the sealing material layers were slightly cloudy. The evaluation results are shown in Table 4.

### (Comparative Example 17)

A 0.4 mm-thick sheet made of EVA (a solar cell sealing material manufactured by SANVIC INC.) was prepared as a sheet sample of Comparative Example 17 and was evaluated in the same manner as in Example 11. As a result, the adhesive strength to glass was 80 N/10 mm width, the moisture transmission rate was 15 {(g/m²·day)/0.4 mm}, and the total light transmittance at 417 nm was 99%. A thin-film solar cell module was produced using this sheet sample, and as a result, this sheet sample exhibited excellent adhesive properties and therefore was not able to be peeled off from the solar cell substrate. Further, a thin-film solar cell module was produced in such a manner as described above using this sheet sample, and as a result, had an excellent appearance. The evaluation results are shown in Table 4.

### (Example 28)

Modified resin pellets were obtained in the same manner as in Example 24, and then 10 parts by weight of a tackifier (YS Polystar T130 manufactured by Yasuhara Chemical Co., Ltd.) was further added to the total amount of the modified resin pellets to obtain tackifier-containing modified resin pellets of Example 28. Then, a sheet sample of Example 28 was obtained with the use of the pellets of Example 28 in the same manner as in Example 11. As a result, the processability was excellent without problems such as drawdown. The total light transmittance at 417 nm of the sheet sample was 87%.

The sheet sample of Example 28 was evaluated in the same manner as in Example 11, and as a result, the moisture transmission rate was 1.4 {(g/m²·day)/0.4 mm}. A crystalline solar cell module was produced using this sheet sample, and as a result, the sealing material layers were cloudy and further yellowish due to the tackifier. The evaluation results are shown in Table 5.

**Table 5**

| | Example 28 | Example 29 | Example 30 | Example 31 | Example 32 |
|---|---|---|---|---|---|
| Polyolefin | EPCP | EBCP | EPCP | EPCP | EPCP |
| Radical Initiator | 0.5 | 0.25 | 0.5 | 0.5 | 0.5 |
| Glycidyl Methacrylate | 5 | 5 | 5 | 5 | 3 |
| Styrene | 5 | 5 | 0 | 0 | 0.1 |
| Tackifier | 10 | 0 | 0 | 10 | 0 |
| Transparency | 87 | 96 | 99 | 87 | 99 |
| Adhesive Properties to Glass | 88 | - | 107 | 115 | 108 |
| Adhesive Properties to Back Sheet | - | - | Adhered | Adhered | Adhered |
| Water Vapor Barrier Properties | 1.4 | 1.5 | 1.5 | 1.4 | 1.5 |
| Processing Time | 13.5 min | 13.5 min | 13.5 min | 13.5 min | 13.5 min |
| Sensory Evaluation of Peeling Properties of Thin-Film Solar Cell Module | A | A | A | A | A |
| Visual Sensory Evaluation of Crystalline Solar Cell Module | C | B | A | C | A |

### (Example 29)

A sheet sample of Example 29 was obtained in the same manner as in Example 14 except that the amount of glycidyl methacrylate (c) added was changed to 5 parts by weight and 5 parts by weight of styrene (d) was further added. As a result, the processability was excellent without problems such as drawdown. The total light transmittance at 417 nm of the sheet sample was 96%.

The sheet sample of Example 29 was evaluated in the same manner as in Example 11, and as a result, the moisture transmission rate was 1.5 {(g/m²·day)/0.4 mm}. A crystalline solar cell module was produced using this sheet sample, and as a result, the sealing material layers were slightly cloudy. The evaluation results are shown in Table 5.

### (Example 30)

Modified resin pellets of Example 30 were obtained in the same manner as in Example 13 except that the amount of glycidyl methacrylate (c) added was changed to 5 parts by weight, and then a sheet sample of Example 30 was obtained in the same manner as in Example 11. As a result, the processability was excellent without problems such as drawdown. The total light transmittance at 417 nm of the sheet sample was 99%.

The sheet sample of Example 30 was evaluated in the same manner as in Example 11, and as a result, the adhesive strength to glass was 115 N/10 mm width and the moisture transmission rate was 1.5 {(g/m²·day)/0.4 mm}. A thin-film solar cell module was produced in such a manner as described above using this sheet sample, and as a result, this sheet sample exhibited excellent adhesive properties. Further, a crystalline solar cell module was produced, and as a result, had an excellent appearance. The evaluation results are shown in Table 5.

The difference between Example 24 and Example 30 is whether styrene is added or not, but a comparison between Example 24 and Example 30 shows that the sheet sample of Example 30 containing no styrene has significantly improved transparency and adhesive properties. However, during production of the sheet sample of Example 30 containing no styrene, the process was sometimes unstable because radical stability in the process of modification was not sufficient as compared to Example 24.

Further, the adhesive strength (adhesive force) of the sheet sample of Example 30 to glass was measured in such a manner as described above in "Adhesive Strength to Glass" while the temperature during deaeration and pressing described above in "Conditions of Integral Molding", that is, the integral molding temperature was changed in the range of 120 to 170°C. The results are shown in Fig. 3 together with the results of the EVA sheet used as a sheet sample of Comparative Example 17. As can be seen from Fig. 3, the solar cell sealing material according to the present invention exhibits an adhesive force equal to or larger than that of EVA when subjected to integral molding at 135°C or higher.

### (Example 31)

Modified resin pellets were obtained in the same manner as in Example 30, and then 10 parts by weight of a tackifier (YS Polystar T130 manufactured by Yasuhara Chemical Co., Ltd.) was further added to the total amount of the modified resin pellets to obtain tackifier-containing modified resin pellets of Example 31. Then, a sheet sample was obtained with the use of the pellets of Example 31 in the same manner as in Example 11. As a result, the processability was excellent without problems such as drawdown. The total light transmittance at 417 nm of the sheet sample was 87%.

The sheet sample of Example 31 was evaluated in the same manner as in Example 11, and as a result, the moisture transmission rate was 1.4 {(g/m²·day)/0.4 mm}. A crystalline solar cell module was produced using this sheet sample, and as a result, the sealing material layers were cloudy and further yellowish due to the tackifier. The evaluation results are shown in Table 5.

The difference between Example 30 and Example 31 is whether the tackifier is added or not. A comparison between Example 30 and Example 31 shows that the tackifier-containing sheet sample of Example 31 has improved adhesive properties to glass and water vapor barrier properties, but has reduced transparency. Therefore, the tackifier-containing sealing material seems to be suitable for use as a thin-film solar cell sealing material for which transparency is not a problem, that is, as the component 3B shown in Fig. 2.

### (Example 32)

Modified resin pellets of Example 32 were obtained in the same manner as in Example 13 except that the amount of glycidyl methacrylate (c) added was reduced to 3 parts by weight and 0.1 part by weight of styrene (d) was further added. Then, a T-die extruded sheet of Example 32 was obtained as a sheet sample of Example 32 in the same manner as in Example 11. As a result, the processability was excellent without problems such as drawdown. The total light transmittance at 417 nm of the sheet sample was 99%.

The sheet sample of Example 32 was evaluated in the same manner as in Example 11, and as a result, the adhesive strength to glass was 108 N/10 mm width and the moisture transmission rate was 1.5 {(g/m²·day)/0.4 mm}. A thin-film solar cell module was produced in such a manner as described above using this sheet sample, and as a result, this sheet sample exhibited excellent adhesive properties. Further, a crystalline solar cell module was produced, and as a result, had an excellent appearance. The evaluation results are shown in Table 5.

A comparison between Example 30 and Example 32 shows that the sheet sample of Example 30 and the sheet sample of Example 32 have substantially the same characteristics. However, the sheet sample of Example 32 containing 0.1 part by weight of styrene was superior to the sheet sample of Example 30 in that the sheet sample of Example 32 was able to be more stably produced as compared to the sheet sample of Example 30 because of sufficient radical stability in the process of modification. Further, the sheet sample of Example 32 was superior to the sheet sample of Example 30 in its odor, which sometimes becomes a problem, and in the amount of the remaining monomer. Further, the sheet sample of Example 32 is superior in cost because the amount of expensive glycidyl methacrylate (GMA) added is smaller.

Further, the modified resin pellets of Example 32 were molded using a calender roll molding machine having smooth-surfaced rolls to prepare a sheet sample having a thickness of 0.4 mm as a calender-molded sheet of Example 32. In this case, the modified resin pellets of Example 32 had an MFR of 40 at 190°C, and an embossed sheet having an arithmetic mean surface roughness (Ra) of 0.01 mm was able to be produced with excellent processability of the modified resin.

Thin-film solar cell modules and crystalline solar cell modules were produced using the calender-molded embossed sheet of Example 32 having an Ra of 0.01 mm and the T-die extruded sheet of Example 32 having a smooth surface. There was no difference in adhesive properties, transparency, and barrier properties between these sheets. However, the calender-molded sheet of Example 32 was superior in handleability. More specifically, the embossed sheet was able to be easily aligned with a sample, and the non-embossed sheet required much time and effort when peeled off. Further, in the case of the embossed sheet, no bubbles remained in the sample after integral molding, but in the case of the T-die extruded sheet having a smooth surface, sealing sometimes was not able to be properly performed due to bubbles partially remaining in the sample. Easy accomplishment of such embossing is one of the features of calender-roll molding, and therefore calender-roll molding is excellent as a method for producing the solar cell molding material sheet according to the present invention.

## Claims

1. A solar cell module sealed with a solar cell sealing material composed of an epoxy-modified polyolefin-based resin composition obtained by introducing epoxy groups by a graft reaction, the solar cell module having a solar cell surface located therein and an end-face seal portion, wherein
the solar cell sealing material is provided so as to come into contact with the solar cell surface, and
the end-face seal portion is sealed with the epoxy-modified polyolefin-based resin composition and includes a planar portion which is in the same plane as the solar cell surface in the solar cell module and where a solar cell is not present.

2. The solar cell module according to claim 1, which comprises a glass plate as a component, wherein the end-face seal portion includes an end face of the glass plate.

3. The solar cell module according to claim 2, which has a surface where the epoxy-modified polyolefin-based resin composition is not present.

4. The solar cell module according to claim 3, wherein the epoxy-modified polyolefin-based resin composition is obtained by introducing epoxy groups by the graft reaction by melt-kneading 100 parts by weight of a polyolefin-based resin (a) with 1 to 5 parts by weight of an epoxy group-containing vinyl monomer (c) and 0 to 1 part by weight of an aromatic vinyl monomer (d) in the presence of 0.05 to 3 parts by weight of a radical polymerization initiator (b).

5. The solar cell module according to any one of claims 1 to 4, wherein the solar cell sealing material is a sheet-shaped molded body obtained by subjecting the modified polyolefin resin composition to extrusion molding or calender roll molding and is also a thermally-weldable sheet molded body not requiring post-crosslinking.

6. The solar cell module according to any one of claims 1 to 5, wherein the solar cell sealing material has any one or more of the following characteristics (1), (2), and (3):
(1) has water vapor barrier properties of less than 2 {(g/m²·day)/0.4 mm};
(2) achieves an adhesive strength of 80 N/10 mm width or more (180° peel test) when adhered to glass at 170°C; and
(3) has a total light transmittance at 417 nm of 97% or more as measured by an integrating sphere method.

7. The solar cell module according to any one of claims 1 to 6, wherein the solar cell sealing material has surface irregularities whose arithmetic mean roughness Ra is 0.001 to 0.2 mm.

8. The solar cell module according to any one of claims 1 to 7, wherein the epoxy-modified polyolefin-based resin composition has a multiple-phase structure in which a phase composed of the polyolefin-based resin (a) contains a phase composed of the epoxy group-containing vinyl monomer (c) and the aromatic vinyl monomer (d) and having an average diameter of 1 µm or less.

9. The solar cell module according to any one of claims 1 to 8, wherein the epoxy-modified polyolefin-based resin composition does not contain a silane coupling agent.

10. The solar cell module according to any one of claims 1 to 9, wherein the epoxy-modified polyolefin-based resin composition further contains 0.1 to 50 parts by weight of a tackifying resin.

11. A method for producing the solar cell module according to any one of claims 1 to 10, the method comprising performing integral molding at 135°C or higher.

12. A method for recycling the solar cell sealing material removed from the solar cell module according to any one of claims 1 to 10, the method comprising molding the solar cell sealing material into a sheet-shaped molded body.

## Patentansprüche

1. Solarzellenmodul, versiegelt mit einem Solarzellendichtungsmaterial, zusammengesetzt aus einer Epoxy-modifiziertes Polyolefin-basierten Harzzusammensetzung, die durch Einbringen von Epoxygruppen durch eine Pfropfreaktion erhalten wurde, wobei das Solarzellenmodul eine darin angeordnete Solarzellenoberfläche und einen stirnseitigen Dichtungsbereich aufweist, wobei
das Solarzellendichtungsmaterial so angeordnet ist, dass es mit der Solarzellenoberfläche in Kontakt kommt, und
der stirnseitige Dichtungsbereich mit der Epoxy-modifiziertes Polyolefin-basierten Harzzusammensetzung versiegelt ist und einen planaren Bereich beinhaltet, der in der gleichen Ebene wie die Solarzellenoberfläche im Solarzellenmodul liegt und worin keine Solarzelle vorhanden ist.

2. Solarzellenmodul nach Anspruch 1, das eine Glasplatte als Bestandteil umfasst, wobei der stirnseitige Dichtungsbereich eine Stirnseite der Glasplatte beinhaltet.

3. Solarzellenmodul nach Anspruch 2, das eine Oberfläche aufweist, auf der keine Epoxy-modifiziertes Polyolefin-basierte Harzzusammensetzung vorhanden ist.

4. Solarzellenmodul nach Anspruch 3, bei dem die Epoxy-modifiziertes Polyolefin-basierte Harzzusammensetzung durch Einbringen von Epoxygruppen durch die Pfropfreaktion erhalten wurde, indem 100 Gewichtsteile eines Polyolefin-basierten Harzes (a) mit 1 bis 5 Gewichtsteilen eines Epoxygruppen enthaltenden Vinylmonomers (c) und 0 bis 1 Gewichtsteilen eines aromatischen Vinylmonomers (d) in Gegenwart von 0,05 bis 3 Gewichtsteilen eines radikalischen Polymerisationsinitiators (b) schmelzgeknetet wurden.

5. Solarzellenmodul nach einem der Ansprüche 1 bis 4, bei dem das Solarzellendichtungsmaterial ein blattförmiger Formkörper, der durch Extrudieren oder Kalandrieren der modifizierten Polyolefinharzzusammensetzung erhalten wurde, und auch ein thermisch schweißbarer Blattformkörper ist, der keine Nachvernetzung erfordert.

6. Solarzellenmodul nach einem der Ansprüche 1 bis 5, bei dem das Solarzellendichtungsmaterial eine oder mehrere der folgenden Eigenschaften (1), (2) und (3) aufweist:
(1) es weist Wasserdampfbarriereeigenschaften von weniger als 2 {(g/m²·Tag)/0,4 mm} auf;
(2) es erreicht eine Haftfestigkeit von 80 N/ 10 mm Breite oder mehr (180°-Abziehtest), wenn es bei 170°C auf Glas angehaftet wird; und
(3) es weist eine Gesamtlichtdurchlässigkeit bei 417 nm von 97% oder mehr, gemessen durch ein Verfahren mit Ulbricht-Kugel, auf.

7. Solarzellenmodul nach einem der Ansprüche 1 bis 6, bei dem das Solarzellendichtungsmaterial Oberflächenunregelmäßigkeiten aufweist, deren arithmetischer Mittenrauwert Ra 0,001 bis 0,2 mm beträgt.

8. Solarzellenmodul nach einem der Ansprüche 1 bis 7, bei dem die Epoxy-modifiziertes Polyolefin-basierte Harzzusammensetzung eine Mehrphasenstruktur aufweist, in der eine Phase aus dem Polyolefin-basierten Harz (a) eine Phase aus dem Epoxygruppen enthaltenden Vinylmonomer (c) und dem aromatischen Vinylmonomer (d) enthält und einen mittleren Durchmesser von 1 µm oder weniger aufweist.

9. Solarzellenmodul nach einem der Ansprüche 1 bis 8, bei dem die Epoxy-modifiziertes Polyolefin-basierte Harzzusammensetzung keinen Silan-Haftvermittler enthält.

10. Solarzellenmodul nach einem der Ansprüche 1 bis 9, bei dem die Epoxy-modifiziertes Polyolefin-basierte Harzzusammensetzung zusätzlich 0,1 bis 50 Gewichtsteile eines klebrigmachenden Harzes enthält.

11. Verfahren zur Herstellung des Solarzellenmoduls nach einem der Ansprüche 1 bis 10, wobei das Verfahren das Integralformen bei 135°C oder höher umfasst.

12. Verfahren zum Recycling des aus dem Solarzellenmodul nach einem der Ansprüche 1 bis 10 entfernten Solarzellendichtungsmaterials, wobei das Verfahren das Formen des Solarzellendichtungsmaterials zu einem blattförmigen Formkörper umfasst.

## Revendications

1. Module de cellule solaire scellé avec un matériau de scellage de cellule solaire composé d'une composition de résine à base de polyoléfine à modification époxy obtenue par l'introduction de groupes époxy par une réaction de greffage, le module de cellule solaire ayant une surface de cellule solaire située à l'intérieur de celui-ci et une partie de scellage de face d'extrémité, où
le matériau de scellage de cellule solaire est prévu de façon à venir en contact avec la surface de cellule solaire, et
la partie de scellage de face d'extrémité est scellée avec la composition de résine à base de polyoléfine à modification époxy et comporte une partie planaire qui est dans le même plan que la surface de cellule solaire dans le module de cellule solaire et où une cellule solaire n'est pas présente.

2. Module de cellule solaire selon la revendication 1, qui comprend une plaque de verre en tant que composant, où la partie de scellage de face d'extrémité comporte une face d'extrémité de la plaque de verre.

3. Module de cellule solaire selon la revendication 2, qui a une surface dans laquelle la composition de résine à base de polyoléfine à modification époxy n'est pas présente.

4. Module de cellule solaire selon la revendication 3, dans lequel la composition de résine à base de polyoléfine à modification époxy est obtenue en introduisant des groupes époxy par la réaction de greffage par malaxage à l'état fondu de 100 parties en poids d'une résine à base de polyoléfine (a) avec 1 à 5 parties en poids d'un monomère de vinyle contenant un groupe époxy (c) et 0 à 1 partie en poids d'un monomère de vinyle aromatique (d) en présence de 0,05 à 3 parties en poids d'un initiateur de polymérisation radicalaire (b).

5. Module de cellule solaire selon l'une quelconque des revendications 1 à 4, dans lequel le matériau de scellage de cellule solaire est un corps moulé en forme de feuille obtenu en soumettant la composition de résine de polyoléfine modifiée à un moulage par extrusion ou à un moulage à la calandre et est également un corps moulé en feuille thermosoudable ne nécessitant pas de post-réticulation.

6. Module de cellule solaire selon l'une quelconque des revendications 1 à 5, dans lequel le matériau de scellage de cellule solaire a l'une quelconque ou plusieurs des caractéristiques (1), (2), et (3) suivantes :
(1) a des propriétés de barrière à la vapeur d'eau de moins de 2 {(g/m²·jour)/0,4mm} ;
(2) permet d'obtenir une force d'adhérence de 80 N/10 mm de largeur ou plus (essai de pelage à 180°) lorsqu'il adhère au verre à 170°C ; et
(3) a une transmittance totale de lumière à 417 nm de 97% ou plus telle que mesurée par une méthode de sphère intégrante.

7. Module de cellule solaire selon l'une quelconque des revendications 1 à 6, dans lequel le matériau de scellage de cellule solaire présente des irrégularités de surface dont la rugosité moyenne arithmétique Ra se trouve dans la plage allant de 0,001 à 0,2 mm.

8. Module de cellule solaire selon l'une quelconque des revendications 1 à 7, dans lequel la composition de résine à base de polyoléfine à modification époxy a une structure à phases multiples dans laquelle une phase composée de la résine à base de polyoléfine (a) contient une phase composée du monomère de vinyle contenant un groupe époxy (c) et du monomère de vinyle aromatique (d) et ayant un diamètre moyen inférieur ou égal à 1 µm.

9. Module de cellule solaire selon l'une quelconque des revendications 1 à 8, dans lequel la composition de résine à base de polyoléfine à modification époxy ne contient pas un agent de couplage au silane.

10. Module de cellule solaire selon l'une quelconque des revendications 1 à 9, dans lequel la composition de résine à base de polyoléfine à modification époxy contient en outre de 0,1 à 50 parties en poids d'une résine donnant du collant.

11. Procédé de production du module de cellule solaire selon l'une quelconque des revendications 1 à 10, le procédé comprenant l'exécution d'un moulage en un seul tenant à 135°C ou plus.

12. Procédé de recyclage du matériau de scellage de cellule solaire retiré du module de cellule solaire selon l'une quelconque des revendications 1 à 10, le procédé comprenant le moulage du matériau de scellage de cellule solaire sous la forme d'un corps moulé en forme de feuille.
